# EUROPEAN PATENT SPECIFICATION

(11) **EP 2 874 195 B1**
(45) Date of publication and mention of the grant of the patent: **03.05.2017**
(21) Application number: 14003725.0
(22) Date of filing: 05.11.2014
(51) Int. Cl.: H01L 51/54

(54) **Organic electroluminescent materials and devices**
Organische elektrolumineszente Materialien und Vorrichtungen
Matériaux et dispositifs électroluminescents organiques

(30) Priority: 15.11.2013 US 201361904530 P; 22.11.2013 US 201361907450 P; 22.10.2014 US 201414521257; 22.10.2014 US 201414521281
(43) Date of publication of application: 20.05.2015
(73) Proprietor: Universal Display Corporation, Ewing, NJ 08618 (US)
(72) Inventor: Xia, Chuanjun, Ewing, NJ New Jersey 08618 (US); Lin, Chun, Ewing, NJ New Jersey 08618 (US)
(74) Representative: Braun, Nils

(56) References cited:
- US-A1- 2005 260 441
- US-A1- 2005 260 448

## Description

### CROSS-REFERENCE TO RELATED APPLICATIONS

This application claims priority to U.S. Provisional Patent Application Serial No. 61/904,530, filed November 15, 2013, and U.S. Provisional Patent Application Serial No. 61/907,450, filed November 22, 2013.

### PARTIES TO A JOINT RESEARCH AGREEMENT

The claimed invention was made by, on behalf of, and/or in connection with one or more of the following parties to a joint university corporation research agreement: Regents of the University of Michigan, Princeton University, University of Southern California, and the Universal Display Corporation. The agreement was in effect on and before the date the claimed invention was made, and the claimed invention was made as a result of activities undertaken within the scope of the agreement.

### FIELD OF THE INVENTION

The present invention relates to compounds for use as emitters and devices, such as organic light emitting diodes, including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Color may be measured using CIE coordinates, which are well known to the art.

One example of a green emissive molecule is tris(2-phenylpyridine) iridium, denoted Ir(ppy)₃, which has the following structure:

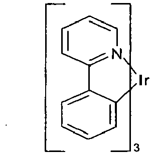

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.

### SUMMARY OF THE INVENTION

According to one embodiment, a compound having the formula Ir(L_{A})ₙ(L_{B})₃₋ₙ, having the structure: 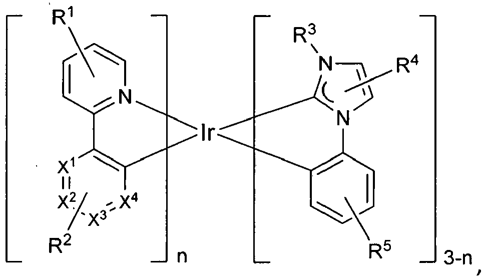 Formula I, is provided. In the structure of Formula I:
R¹ and R⁵ each independently represent mono, di, tri, or tetra-substitution, or no substitution;
R² represents up to tri-substitution, or no substitution;
R⁴ represents mono, or di-substitution, or no substitution;
X¹, X², X³, and X⁴ are each independently C or N;
at least one of X¹, X², X³ , and X⁴ is N;
any adjacent substituents of R¹ R², R³, R⁴, and R⁵ are optionally linked together to form a ring;
each of R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
n is either 1 or 2.

According to another embodiment, a first device comprising a first organic light emitting device is also provided. The first organic light emitting device can include an anode, a cathode, and an organic layer, disposed between the anode and the cathode. The organic layer can include a compound of the formula Ir(L_{A})ₙ(L_{B})₃₋ₙ. The first device can be one or more of a consumer product, an electronic component module, an organic light-emitting device, and a lighting panel.

Formulations containing a compound of the formula Ir(L_{A})ₙ(L_{B})₃₋ₙ are also provided.

### BRIEF DESCRIPTION OF THE DRAWINGS

FIG. 1 shows an organic light emitting device.
FIG. 2 shows an inverted organic light emitting device that does not have a separate electron transport layer.

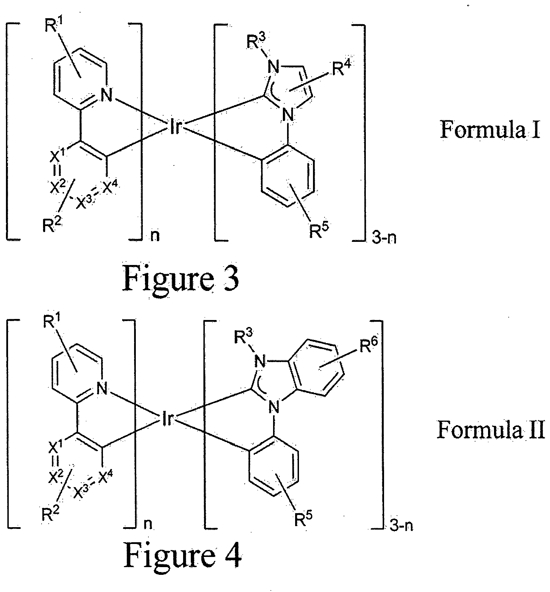

FIG. 3 shows Formula I as disclosed herein.
FIG. 4 shows Formula II as disclosed herein.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

An example of phosphorescent complexes includes iridium complexes such as those disclosed in US 2005/0260441 A1.

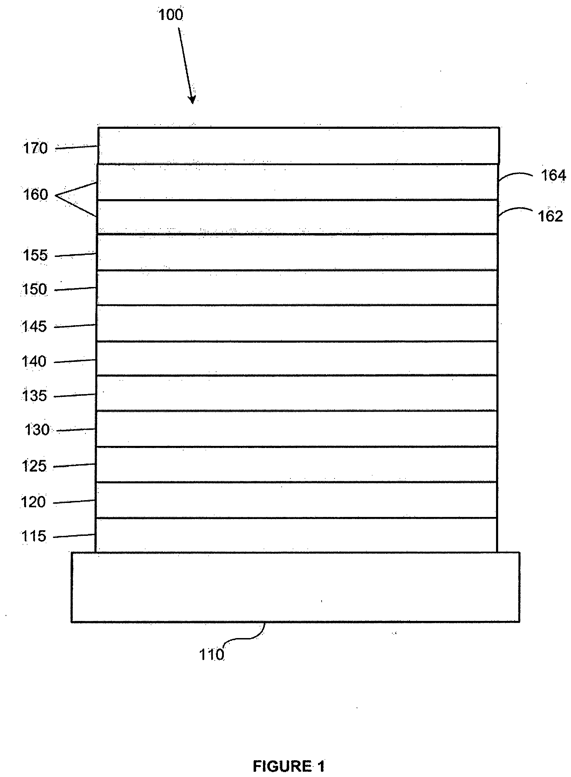

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/02309890. Examples of injection layers are provided in U.S. Patent Application Publication No. 2004/0174116. A description of protective layers may be found in U.S. Patent Application Publication No. 2004/0174116.

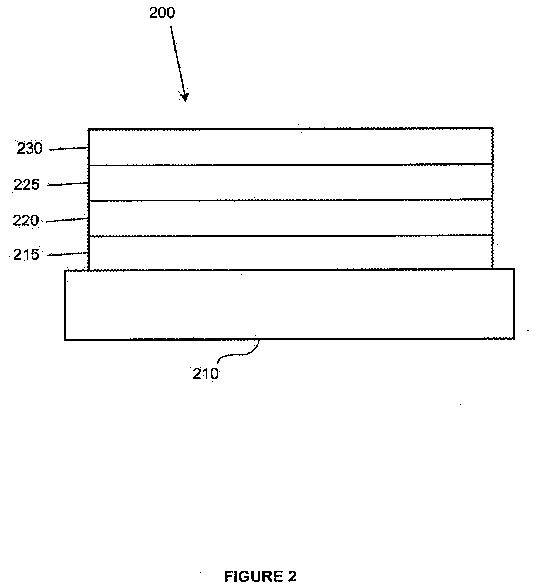

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, cell phones, tablets, phablets, personal digital assistants (PDAs), laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C), but could be used outside this temperature range, for example, from -40 degree C to + 80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The term "halo," "halogen," or "halide" as used herein includes fluorine, chlorine, bromine, and iodine.

The term "alkyl" as used herein contemplates both straight and branched chain alkyl radicals. Preferred alkyl groups are those containing from one to fifteen carbon atoms and includes methyl, ethyl, propyl, isopropyl, butyl, isobutyl, tert-butyl, and the like. Additionally, the alkyl group may be optionally substituted.

The term "cycloalkyl" as used herein contemplates cyclic alkyl radicals. Preferred cycloalkyl groups are those containing 3 to 7 carbon atoms and includes cyclopropyl, cyclopentyl, cyclohexyl, and the like. Additionally, the cycloalkyl group may be optionally substituted.

The term "alkenyl" as used herein contemplates both straight and branched chain alkene radicals. Preferred alkenyl groups are those containing two to fifteen carbon atoms. Additionally, the alkenyl group may be optionally substituted.

The term "alkynyl" as used herein contemplates both straight and branched chain alkyne radicals. Preferred alkynyl groups are those containing two to fifteen carbon atoms. Additionally, the alkynyl group may be optionally substituted.

The terms "aralkyl" or "arylalkyl" as used herein are used interchangeably and contemplate an alkyl group that has as a substituent an aromatic group. Additionally, the aralkyl group may be optionally substituted.

The term "heterocyclic group" as used herein contemplates aromatic and non-aromatic cyclic radicals. Hetero-aromatic cyclic radicals also means heteroaryl. Preferred hetero-non-aromatic cyclic groups are those containing 3 or 7 ring atoms which includes at least one hetero atom, and includes cyclic amines such as morpholino, piperdino, pyrrolidino, and the like, and cyclic ethers, such as tetrahydrofuran, tetrahydropyran, and the like. Additionally, the heterocyclic group may be optionally substituted.

The term "aryl" or "aromatic group" as used herein contemplates single-ring groups and polycyclic ring systems. The polycyclic rings may have two or more rings in which two carbons are common to two adjoining rings (the rings are "fused") wherein at least one of the rings is aromatic, e.g., the other rings can be cycloalkyls, cycloalkenyls, aryl, heterocycles, and/or heteroaryls. Additionally, the aryl group may be optionally substituted.

The term "heteroaryl" as used herein contemplates single-ring hetero-aromatic groups that may include from one to three heteroatoms, for example, pyrrole, furan, thiophene, imidazole, oxazole, thiazole, triazole, pyrazole, pyridine, pyrazine and pyrimidine, and the like. The term heteroaryl also includes polycyclic hetero-aromatic systems having two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. Additionally, the heteroaryl group may be optionally substituted.

The alkyl, cycloalkyl, alkenyl, alkynyl, aralkyl, heterocyclic group, aryl, and heteroaryl may be optionally substituted with one or more substituents selected from the group consisting of hydrogen, deuterium, halogen, alkyl, cycloalkyl, heteroalkyl, arylalkyl, alkoxy, aryloxy, amino, cyclic amino, silyl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, and combinations thereof.

As used herein, "substituted" indicates that a substituent other than H is bonded to the relevant position, such as carbon. Thus, for example, where R¹ is mono-substituted, then one R¹ must be other than H. Similarly, where R¹ is di-substituted, then two of R¹ must be other than H. Similarly, where R¹ is unsubstituted, R¹ is hydrogen for all available positions.

The "aza" designation in the fragments described herein, i.e. aza-dibenzofuran, aza-dibenzothiophene, etc. means that one or more of the C-H groups in the respective fragment can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

According to one embodiment, a compound having the formula Ir(L_{A})ₙ(L_{B})₃₋ₙ, having the structure: 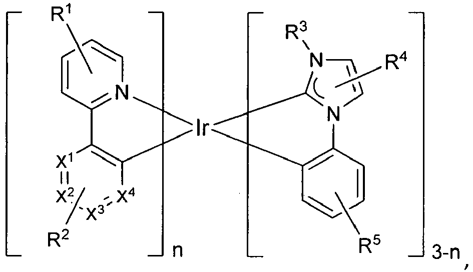 Formula I, is disclosed.

In the structure of Formula I:
R¹ and R⁵ each independently represent mono, di, tri, or tetra-substitution, or no substitution;
R² represents up to tri-substitution, or no substitution;
R⁴ represents mono, or di-substitution, or no substitution;
X¹, X², X³, and X⁴ are each independently C or N;
at least one of X¹, X², X³, and X⁴ is N;
any adjacent substituents of R¹, R², R³, R⁴, and R⁵ are optionally linked together to form a ring;
each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
n is either 1 or 2.

In some embodiments, two adjacent substituents of R⁴ can form a fused ring. In some embodiments, the fused ring can be aryl or heteroaryl. In some embodiments, the fused ring can be phenyl or pyridyl.

In some embodiments, n is 1. In some embodiments, n is 2.

In some embodiments, the compound has the structure of Formula II: 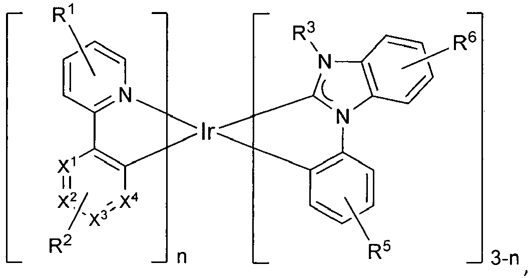 Formula II.

In the structure of Formula II:
R⁶ represents mono, di, tri, or tetra-substitution, or no substitution;
any adjacent substitutions of R⁶ are optionally linked together to form a ring; and
each R⁶ is independently selected from the group consisting of hydrogen,
deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In some embodiments, only one of X¹, X², X³, and X⁴ is N. In some embodiments, only two of X¹, X², X³, and X⁴ are N. In some embodiments, exactly three of X¹, X², X³, and X⁴ are N, while in some embodiments all four of X¹, X², X³, and X⁴ are N. In some embodiments, X² is N.

In some embodiments, R¹ is selected from the group consisting of hydrogen, deuterium, alkyl, cycloalkyl, and combinations thereof. In some embodiments, R² is selected from the group consisting of hydrogen, deuterium, halide, alkyl, cycloalkyl, nitrile, and combinations thereof. In some embodiments, each halide is independently selected from the group consisting of fluoride, chloride, dromide, and iodide.

In some embodiments, R³ is alkyl or cycloalkyl. In some embodiments, R³ is aryl or substituted aryl. In some embodiments, R³ is selected from the group consisting of: ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, and cyclohexyl, wherein each group is optionally partially or fully deuterated.

In some embodiments, the compound is selected from the group consisting of:

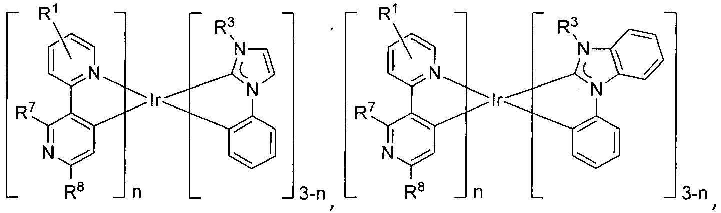

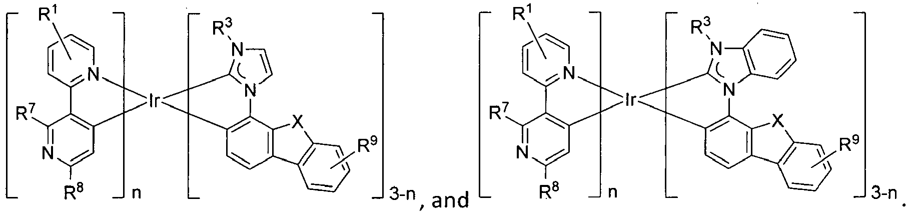

In these structures:
R⁹ represents mono, di, tri, or tetra-substitution, or no substitution;
each R⁷, R⁸, and R⁹ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
X is O or S.

In some embodiments, R⁹ can be selected from the group consisting of ethyl, propyl, 1-methylethyl, butyl, 1-methylpropyl, 2-methylpropyl, wherein each group is optionally partially or fully deuterated.

In some embodiments, L_{A} is selected from the group consisting of:

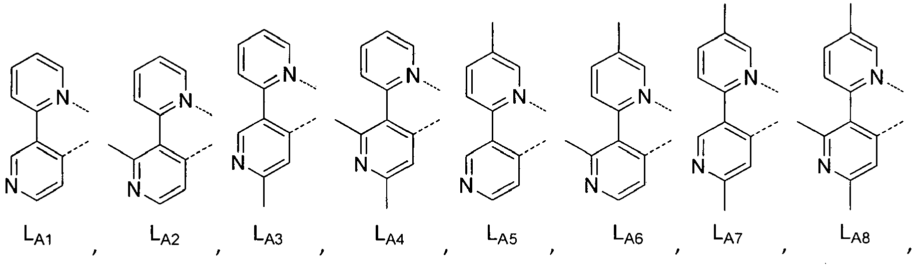

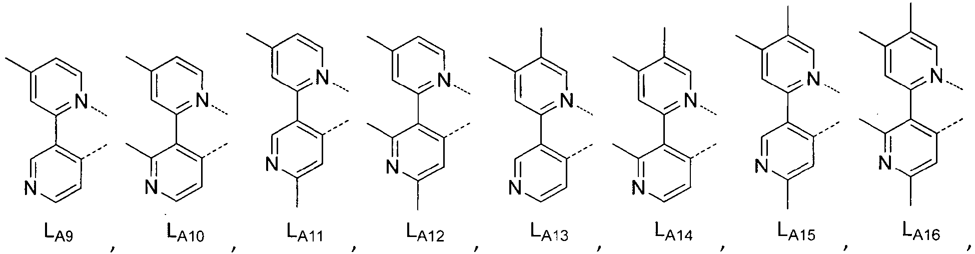

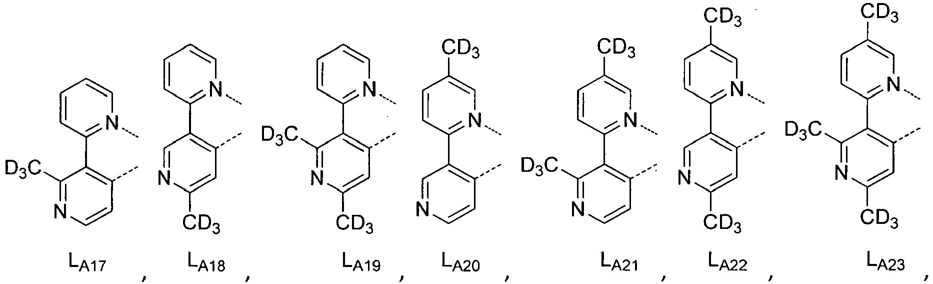

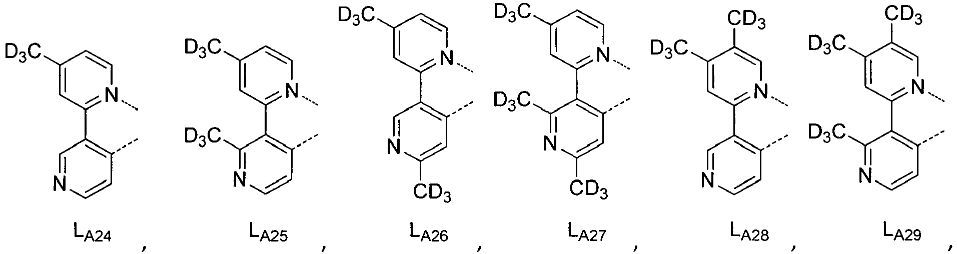

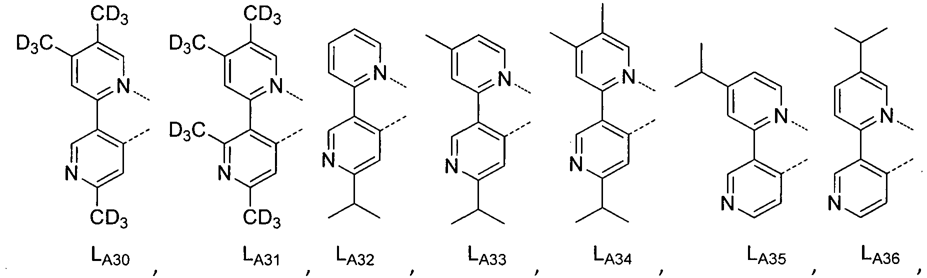

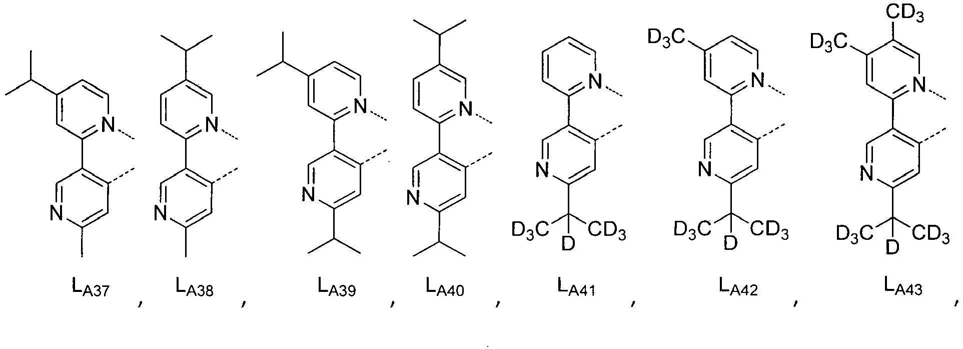

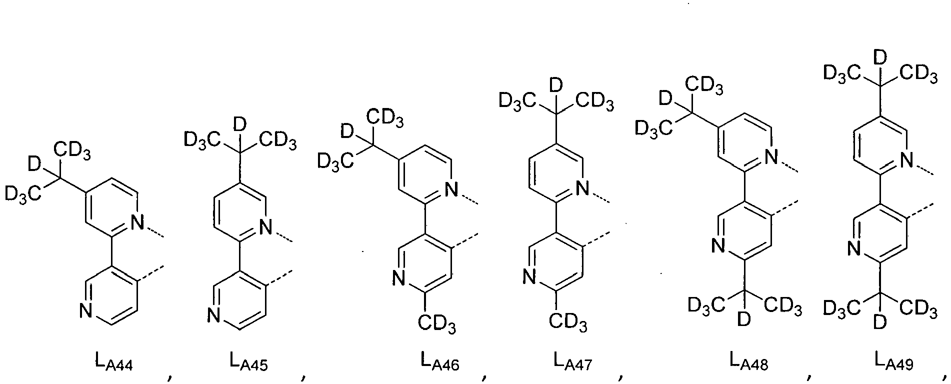

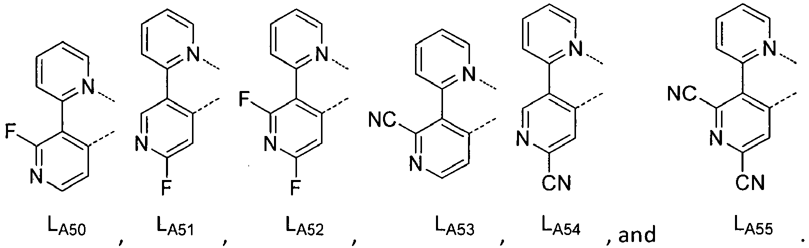

In some embodiments, L_{B} is selected from the group consisting of: 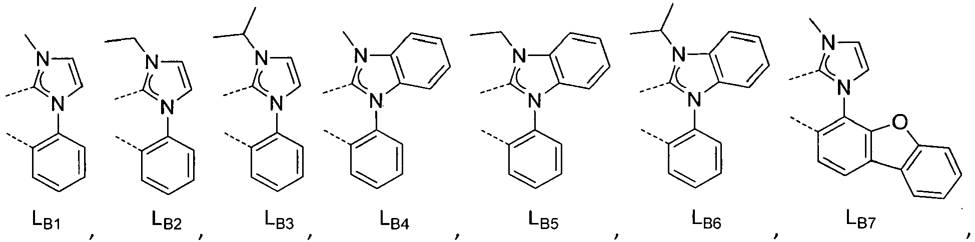 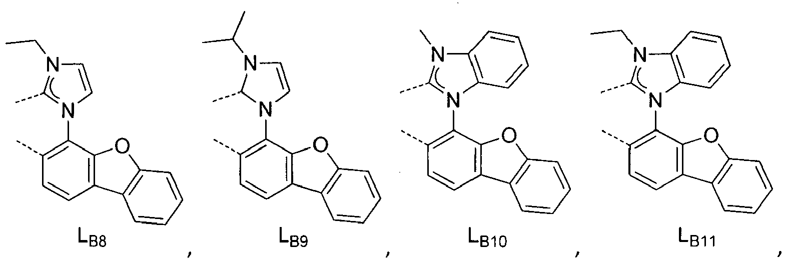 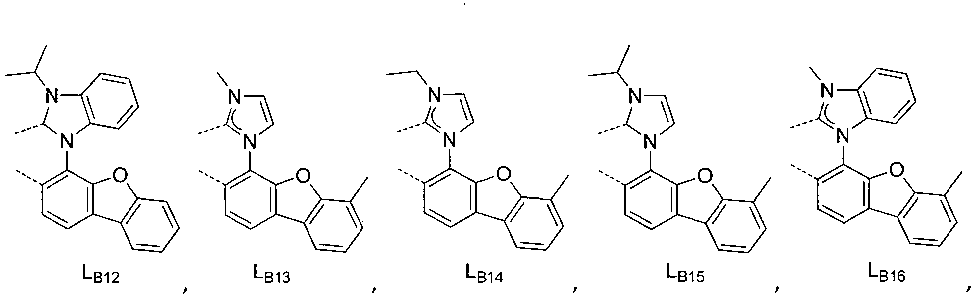 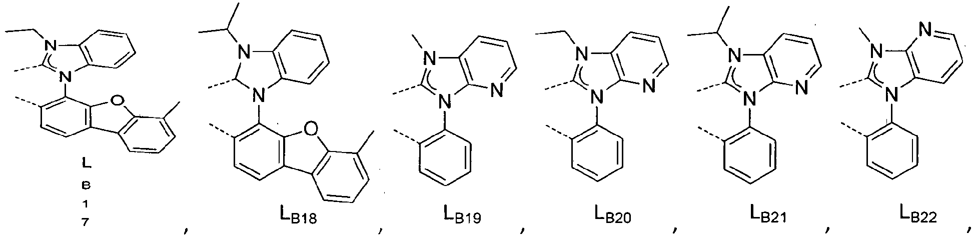 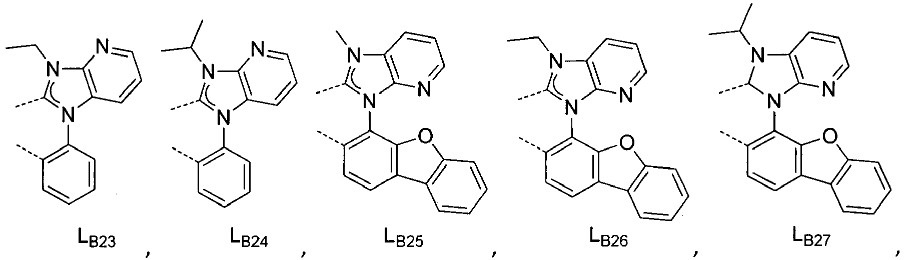 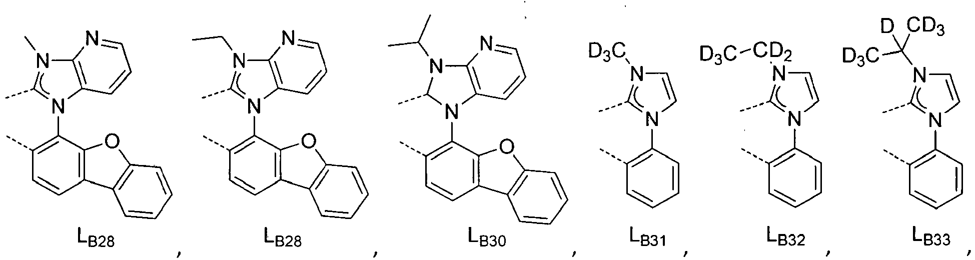 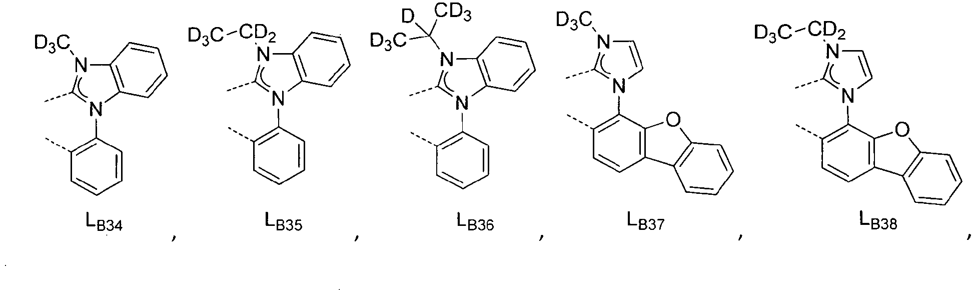 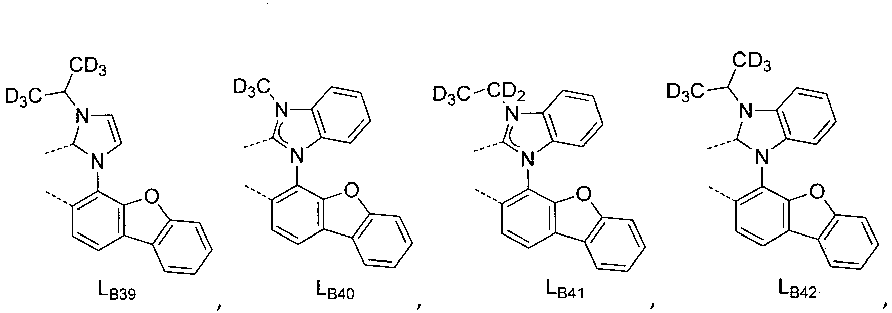 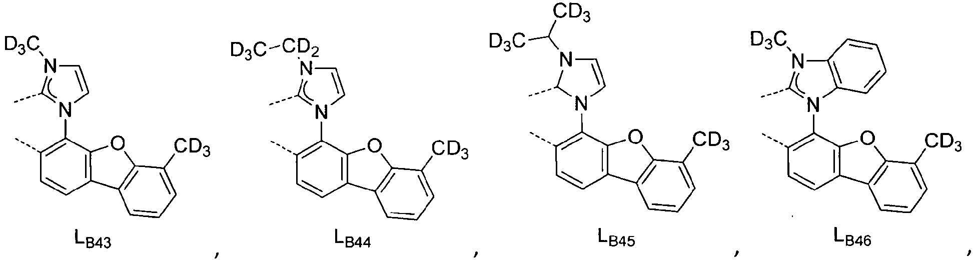 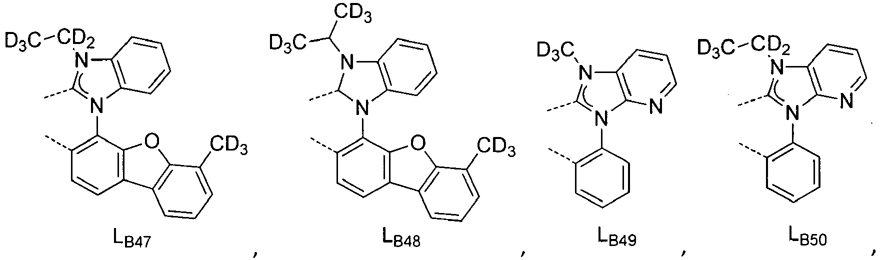 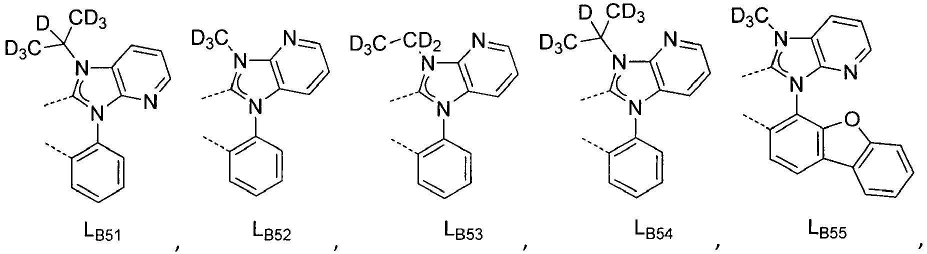 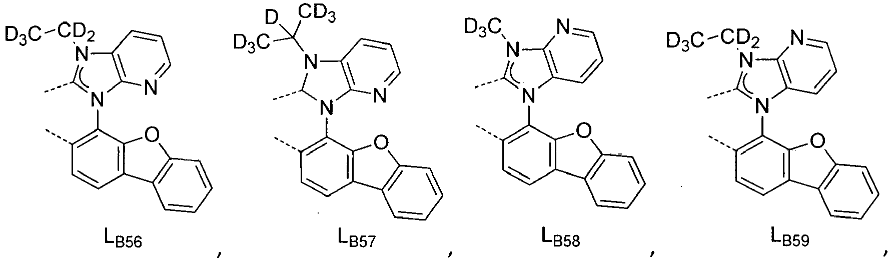 and

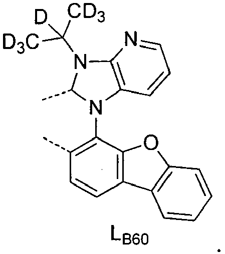

In some embodiments, the compound is selected from Compound 1 to 3300, where ligands L_{A} and L_{B} are as described herein, n is 2, and where each Compound *x* has the formula Ir(L_{A*k*})₂(L_{B*j*}), wherein *x* = 55*j* + *k -* 55, *k* is an integer from 1 to 55, and *j* is an integer from 1 to 60.

In some embodiments, the compound can be an emissive dopant. In some embodiments, the compound can produce emissions via phosphorescence, fluorescence, thermally activated delayed fluorescence, *i.e.*, TADF (also referred to as E-type delayed fluorescence), triplet-triplet annihilation, or combinations of these processes.

According to another aspect of the present disclosure, a first device is also provided. The first device includes a first organic light emitting device, that includes an anode, a cathode, and an organic layer disposed between the anode and the cathode. The organic layer can include a compound according to Formula Ir(L_{A})ₙ(L_{B})₃₋ₙ, and its variants, as described herein. In some embodiments, the organic layer includes a host and a phosphorescent dopant.

The first device can be one or more of a a consumer product, an electronic component module, an organic light-emitting device, and a lighting panel. The organic layer can be an emissive layer and the compound can be an emissive dopant in some embodiments, while the compound can be a non-emissive dopant in other embodiments.

The organic layer can also include a host. In some embodiments, the host can include a metal complex. The host can be a triphenylene containing benzo-fused thiophene or benzo-fused furan. Any substituent in the host can be an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁ Ar₁-Ar₂, and CₙH₂ₙ-Ar₁, or no substitution. In the preceding substituents n can range from 1 to 10; and Ar₁ and Ar₂ can be independently selected from the group consisting of benzene, biphenyl, naphthalene, triphenylene, carbazole, and heteroaromatic analogs thereof.

The host can be a compound comprising at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene. The host can include a metal complex. The host can be a specific compound selected from the group consisting of: 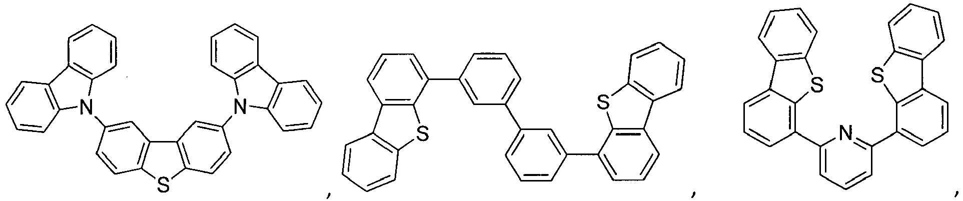 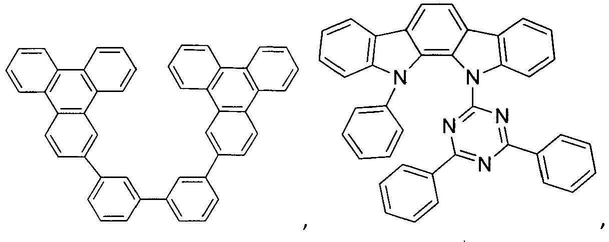 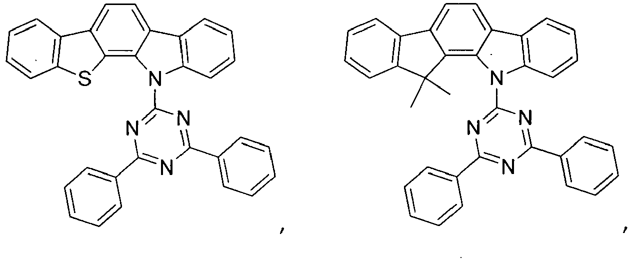 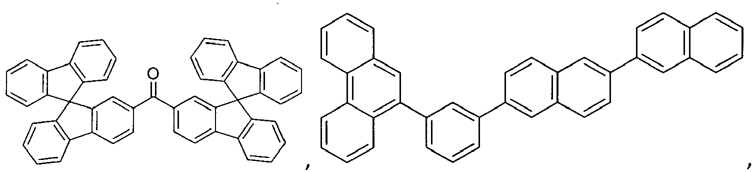 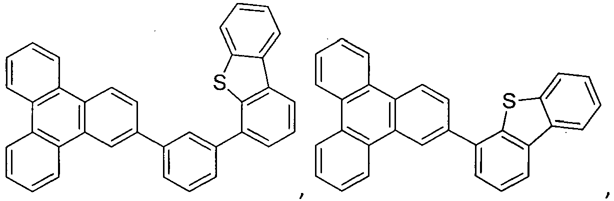 and combinations thereof.

In yet another aspect of the present disclsoure, a formulation that comprises a compound according to Formula Ir(L_{A})ₙ(L_{B})₃₋ₙ, and its variations described herein, is described. The formulation can include one or more components selected from the group consisting of a solvent, a host, a hole injection material, hole transport material, and an electron transport layer material, disclosed herein.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### HIL/HTL:

A hole injecting/transporting material to be used in the present invention is not particularly limited, and any compound may be used as long as the compound is typically used as a hole injecting/transporting material. Examples of the material include, but not limit to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

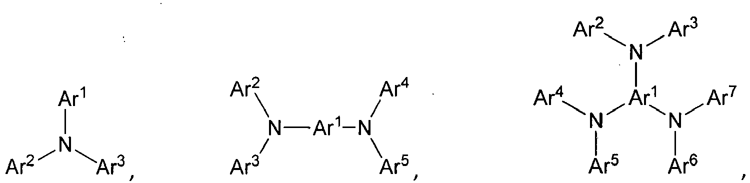

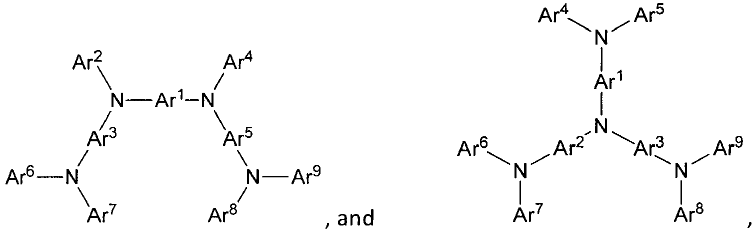

Each of Ar₁ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each Ar is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 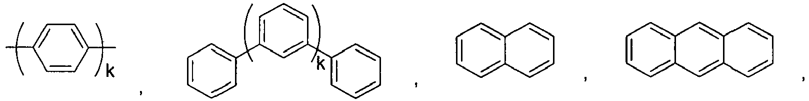 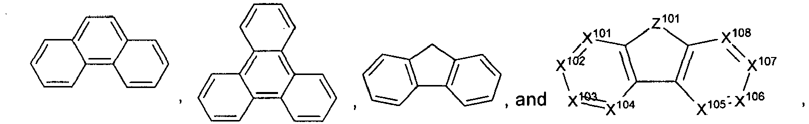 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but not limit to the following general formula: 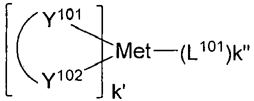 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. While the Table below categorizes host materials as preferred for devices that emit various colors, any host material may be used with any dopant so long as the triplet criteria is satisfied.

Examples of metal complexes used as host are preferred to have the following general formula: 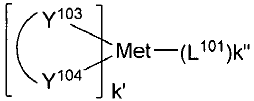 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 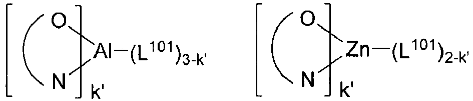 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

Examples of organic compounds used as host are selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each group is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, the host compound contains at least one of the following groups in the molecule: 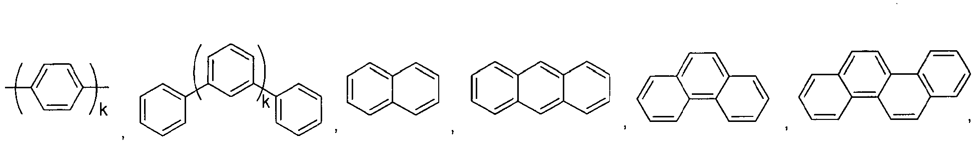 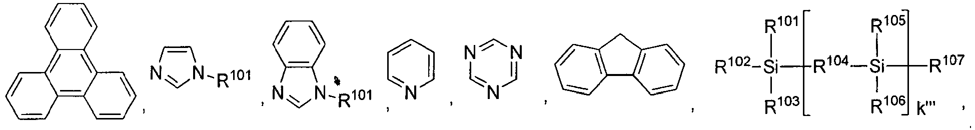 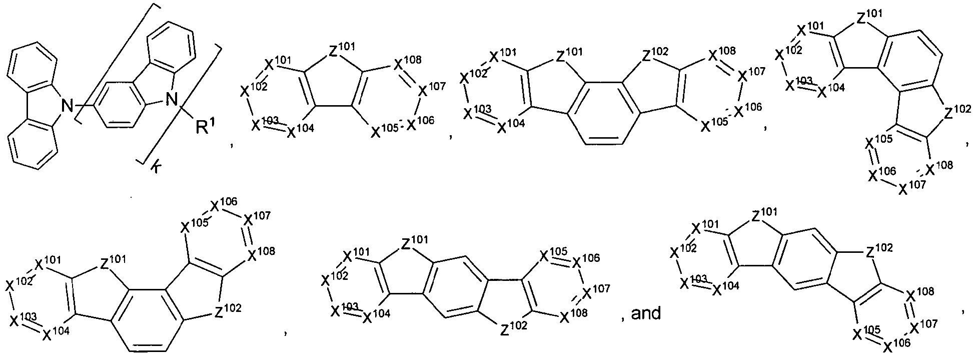 wherein R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. k is an integer from 0 to 20 or 1 to 20; k'" is an integer from 0 to 20. X¹⁰¹ to X¹⁰⁸ is selected from C (including CH) or N.
Z¹⁰¹ and Z¹⁰² is selected from NR¹⁰¹, O, or S.

### HBL:

A hole blocking layer (HBL) may be used to reduce the number of holes and/or excitons that leave the emissive layer. The presence of such a blocking layer in a device may result in substantially higher efficiencies as compared to a similar device lacking a blocking layer. Also, a blocking layer may be used to confine emission to a desired region of an OLED.

In one aspect, compound used in HBL contains the same molecule or the same functional groups used as host described above.

In another aspect, compound used in HBL contains at least one of the following groups in the molecule: 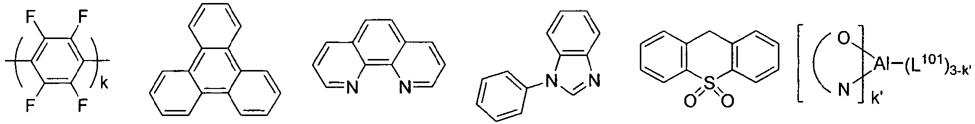 wherein k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 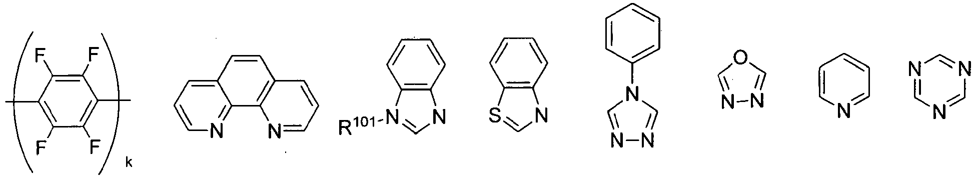 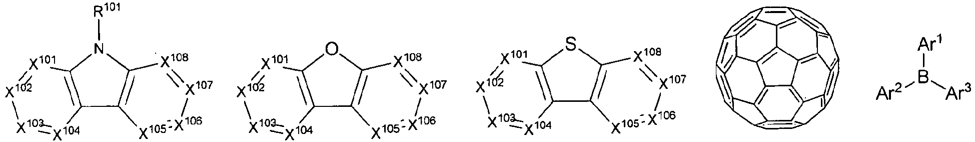 wherein R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 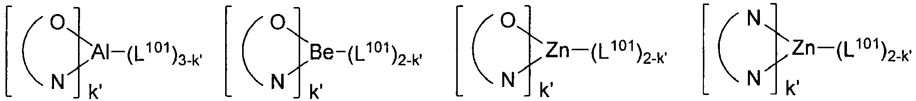 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

In any above-mentioned compounds used in each layer of the OLED device, the hydrogen atoms can be partially or fully deuterated. Thus, any specifically listed substituent, such as, without limitation, methyl, phenyl, pyridyl, etc. encompasses undeuterated, partially deuterated, and fully deuterated versions thereof. Similarly, classes of substituents such as, without limitation, alkyl, aryl, cycloalkyl, heteroaryl, etc. also encompass undeuterated, partially deuterated, and fully deuterated versions thereof.

In addition to and / or in combination with the materials disclosed herein, many hole injection materials, hole transporting materials, host materials, dopant materials, exiton/hole blocking layer materials, electron transporting and electron injecting materials may be used in an OLED. Non-limiting examples of the materials that may be used in an OLED in combination with materials disclosed herein are listed in Table A below. Table A lists non-limiting classes of materials, non-limiting examples of compounds for each class, and references that disclose the materials.

**TABLE A**

| **MATERIAL** | **EXAMPLES OF MATERIAL** | **PUBLICATIONS** |
|---|---|---|
| **Hole injection materials** | | |
| Phthalocyanine and porphyrin compounds | 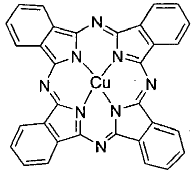 | Appl. Phys. Lett. 69, 2160(1996) |
| Starburst triarylamines | 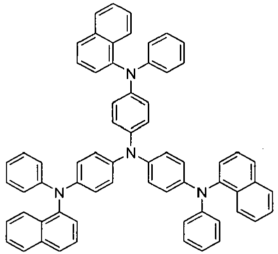 | J. Lumin. 72-74, 985 (1997) |
| CFₓ Fluorohydrocarbon polymer | 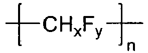 | Appl. Phys. Lett. 78, 673 (2001) |
| Conducting polymers | 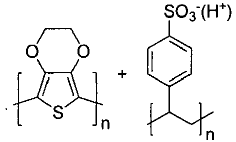 | Synth. Met. 87, 171 (1997) |
| (e.g., PEDOT:PSS, polyaniline, polythiophene) | | WO2007002683 |
| Phosphonic acid and silane SAMs | 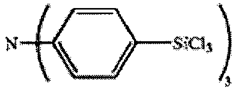 | US20030162053 |
| Triarylamine or polythiophene polymers with conductivity dopants | 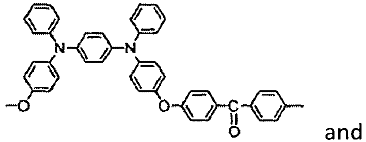 | EP1725079A1 |
| | 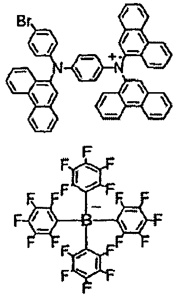 | |
| Organic compounds with conductive inorganic compounds, such as molybdenum and tungsten oxides | 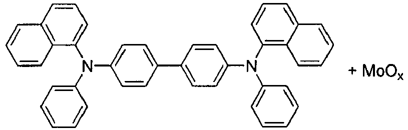 | US20050123751 |
| | | SID Symposium Digest, 37, 923 (2006) |
| | | WO2009018009 |
| n-type semiconducting organic complexes | 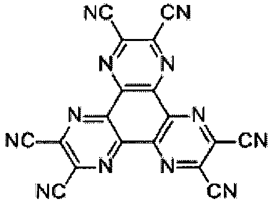 | US20020158242 |
| Metal organometallic complexes | 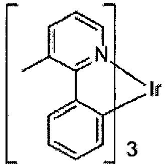 | US20060240279 |
| Cross-linkable compounds | 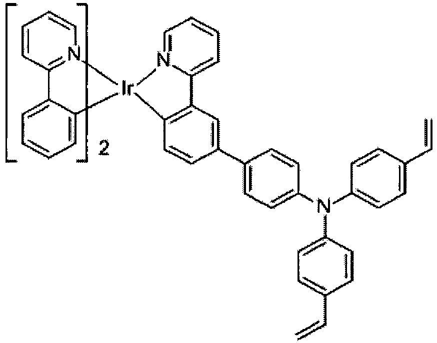 | US20080220265 |
| Polythiophene based polymers and copolymers | 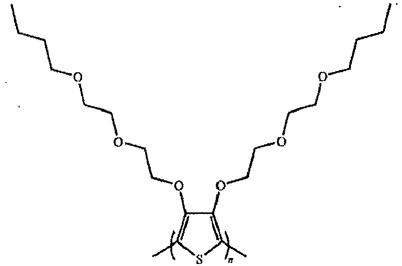 | WO 2011075644 |
| | | EP2350216 |
| **Hole transporting materials** | | |
| Triarylamines | 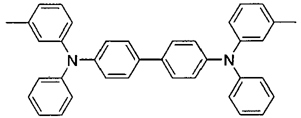 | Appl. Phys. Lett. 51, 913 (1987) |
| (e.g., TPD, α-NPD) | | |
| | 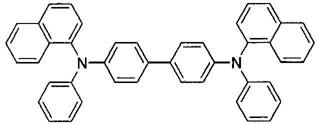 | US5061569 |
| | 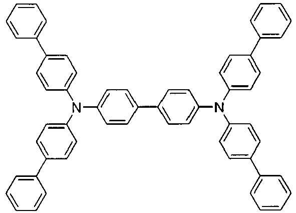 | EP650955 |
| | 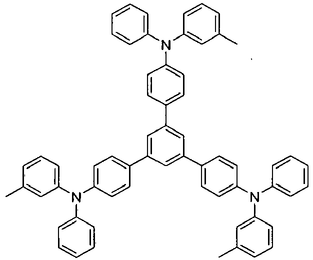 | J. Mater. Chem. 3, 319 (1993) |
| | 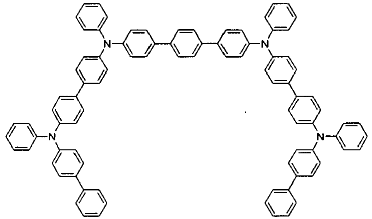 | Appl. Phys. Lett. 90, 183503 (2007) |
| | 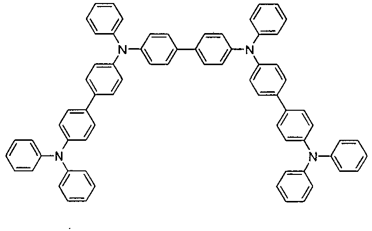 | Appl. Phys. Lett. 90, 183503 (2007) |
| Triarylamine on spirofluorene core | 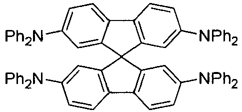 | Synth. Met. 91, 209 (1997) |
| Arylamine carbazole compounds | 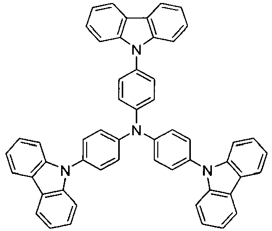 | Adv. Mater. 6, 677 (1994), US20080124572 |
| Triarylamine with (di)benzothiophene/(di)be nzofuran | 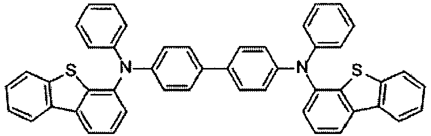 | US20070278938, US20080106190 |
| | | US20110163302 |
| Indolocarbazoles | 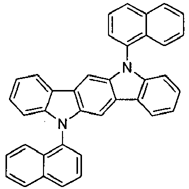 | Synth. Met. 111, 421 (2000) |
| Isoindole compounds | 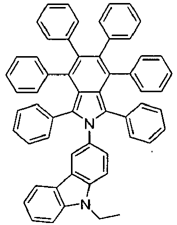 | Chem. Mater. 15, 3148 (2003) |
| Metal carbene complexes | 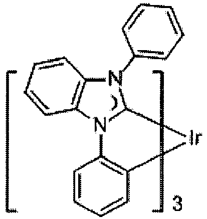 | US20080018221 |
| **Phosphorescent OLED host materials** | | |
| **Red hosts** | | |
| Arylcarbazoles | 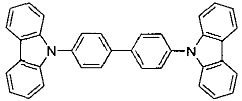 | Appl. Phys. Lett. 78, 1622 (2001) |
| Metal 8-hydroxyquinolates | 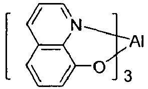 | Nature 395, 151 (1998) |
| (e.g., Alq₃, BAlq) | 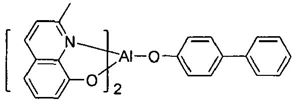 | US20060202194 |
| | 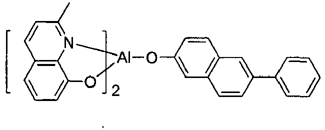 | WO2005014551 |
| | 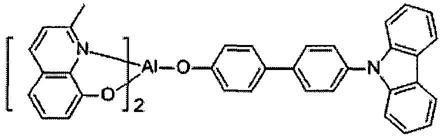 | WO2006072002 |
| Metal phenoxybenzothiazole compounds | 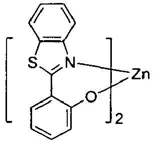 | Appl. Phys. Lett. 90, 123509 (2007) |
| Conjugated oligomers and polymers | 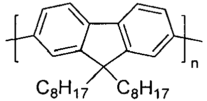 | Org. Electron. 1, 15 (2000) |
| (e.g., polyfluorene) | | |
| Aromatic fused rings | 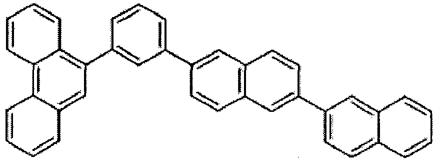 | WO2009066779, WO2009066778, WO2009063833, US20090045731, US20090045730, |
| | | WO2009008311, US20090008605, US20090009065 |
| Zinc complexes | 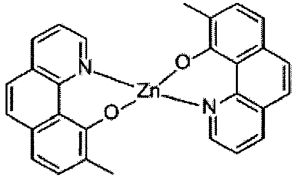 | WO2010056066 |
| Chrysene based compounds | 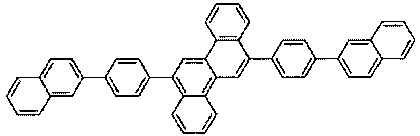 | WO2011086863 |
| **Green hosts** | | |
| Arylcarbazoles | 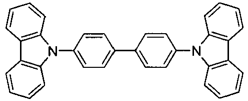 | Appl. Phys. Lett. 78, 1622 (2001) |
| | 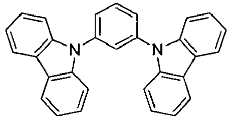 | US20030175553 |
| | 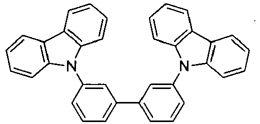 | WO2001039234 |
| Aryltriphenylene compounds | 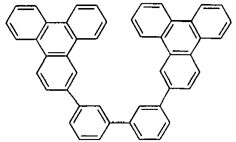 | US20060280965 |
| | 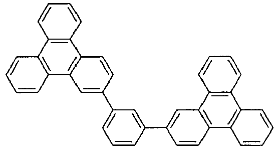 | US20060280965 |
| | 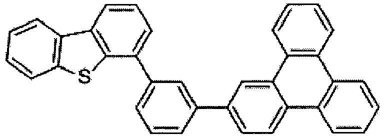 | WO2009021126 |
| Poly-fused heteroaryl compounds | 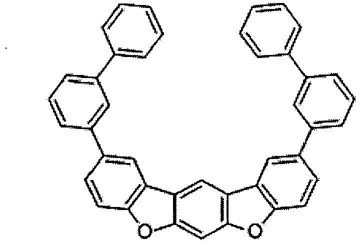 | US20090309488 |
| | | US20090302743 |
| | | US20100012931 |
| | | |
| Donor acceptor type molecules | 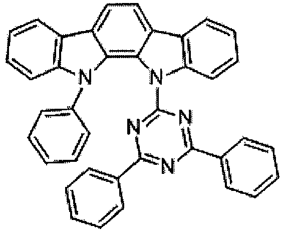 | WO2008056746 |
| | 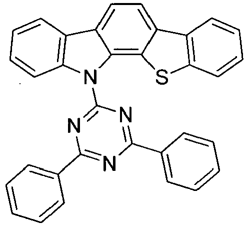 | WO2010107244 |
| Aza-carbazole/DBT/DBF | 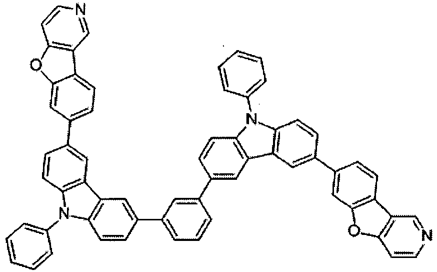 | JP2008074939 |
| | 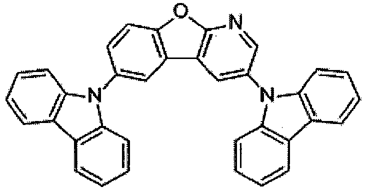 | US20100187984 |
| Polymers (e.g., PVK) | 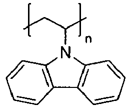 | Appl. Phys. Lett. 77, 2280(2000) |
| Spirofluorene compounds | 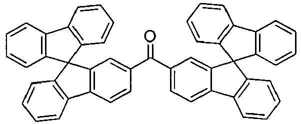 | WO2004093207 |
| Metal phenoxybenzooxazole compounds | 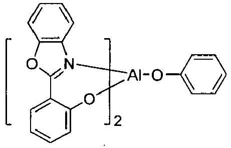 | WO2005089025 |
| | 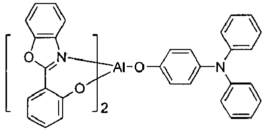 | WO2006132173 |
| | 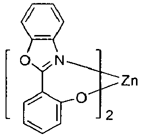 | JP200511610 |
| Spirofluorene-carbazole compounds | 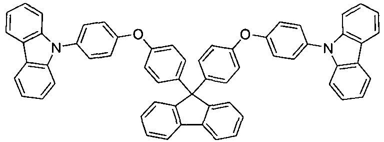 | JP2007254297 |
| | 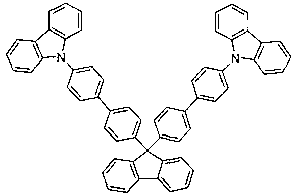 | JP2007254297 |
| Indolocarbazoles | 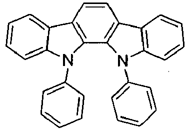 | WO2007063796 |
| | 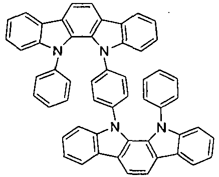 | WO2007063754 |
| 5-member ring electron deficient heterocycles | 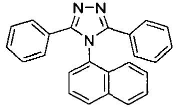 | J. Appl. Phys. 90, 5048 (2001) |
| (e.g., triazole, oxadiazole) | 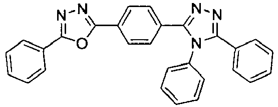 | WO2004107822 |
| Tetraphenylene complexes | 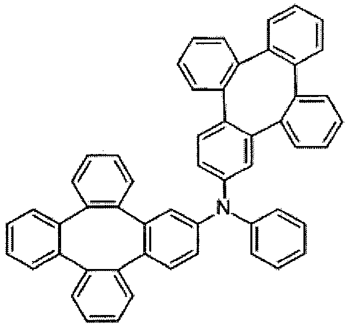 | US20050112407 |
| Metal phenoxypyridine compounds | 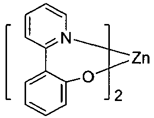 | WO2005030900 |
| Metal coordination complexes (e.g., Zn, Al with N^N ligands) | 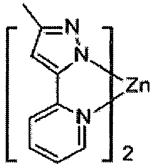 | US20040137268, US20040137267 |
| **Blue hosts** | | |
| Arylcarbazoles | 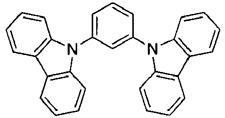 | Appl. Phys. Lett, 82, 2422(2003) |
| | 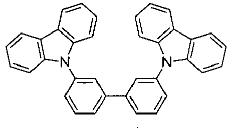 | US20070190359 |
| Dibenzothiophene/Dibenz ofuran-carbazole compounds | 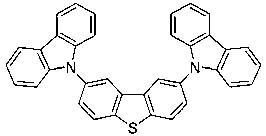 | WO2006114966, US20090167162 |
| | 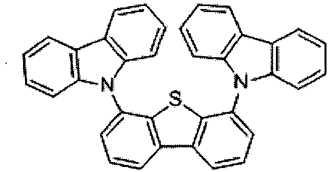 | US20090167162 |
| | 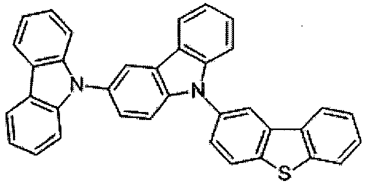 | WO2009086028 |
| | 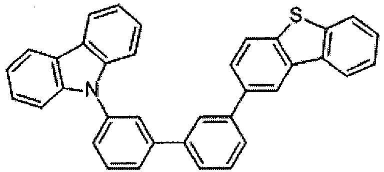 | US20090030202, US20090017330 |
| | 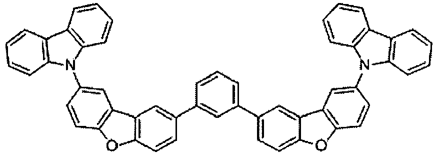 | US20100084966 |
| Silicon aryl compounds | 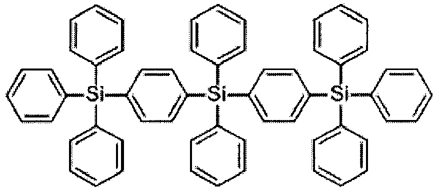 | US20050238919 |
| | 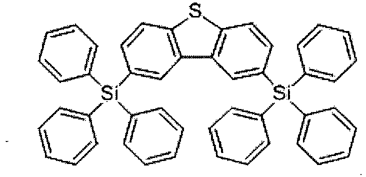 | WO2009003898 |
| Silicon/Germanium aryl compounds | 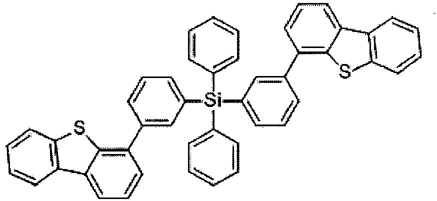 | EP2034538A |
| Aryl benzoyl ester | 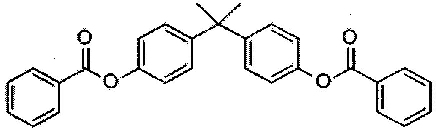 | WO2006100298 |
| Carbazole linked by nonconjugated groups | 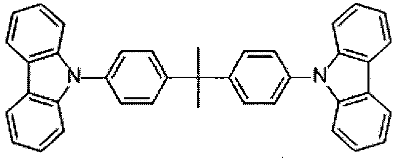 | US20040115476 |
| Aza-carbazoles | 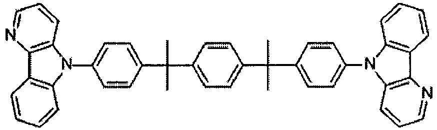 | US20060121308 |
| High triplet metal organometallic complex | 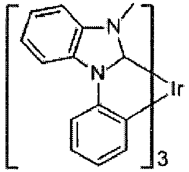 | US7154114 |
| **Phosphorescent dopants** | | |
| **Red dopants** | | |
| Heavy metal porphyrins | 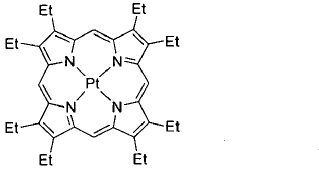 | Nature 395, 151 (1998) |
| (e.g., PtOEP) | | |
| Iridium(III) organometallic complexes | 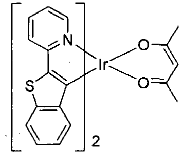 | Appl. Phys. Lett. 78, 1622 (2001) |
| | 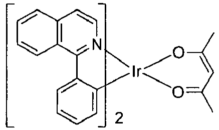 | US20030072964 |
| | 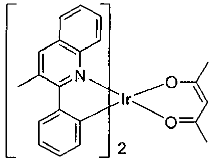 | US20030072964 |
| | 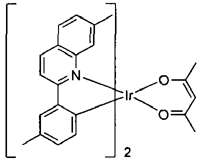 | US20060202194 |
| | 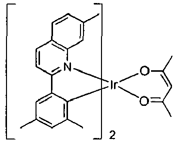 | US20060202194 |
| | 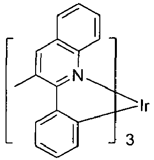 | US20070087321 |
| | 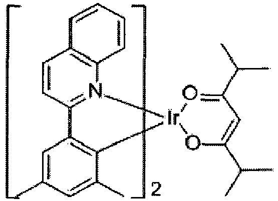 | US20080261076 |
| | | US20100090591 |
| | 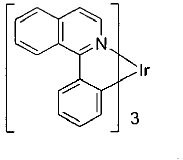 | US20070087321 |
| | 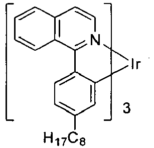 | Adv. Mater. 19, 739 (2007) |
| | 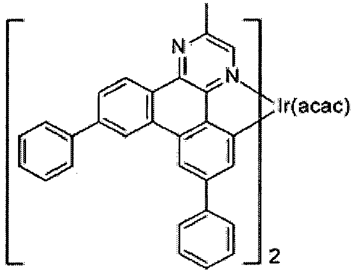 | WO2009100991 |
| | 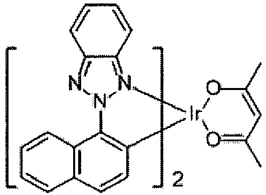 | WO2008101842 |
| | 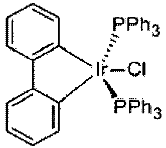 | US7232618 |
| Platinum(II) organometallic complexes | 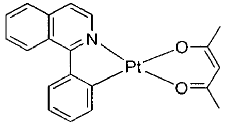 | WO2003040257 |
| | 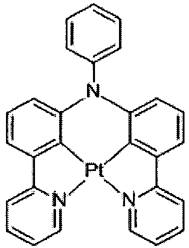 | US20070103060 |
| Osmium(III) complexes | 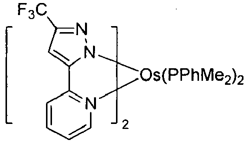 | Chem. Mater. 17, 3532 (2005) |
| Ruthenium(II) complexes | 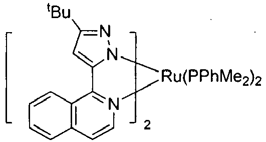 | Adv. Mater. 17, 1059 (2005) |
| Rhenium (I), (II), and (III) complexes | 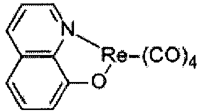 | US20050244673 |
| **Green dopants** | | |
| Iridium(III) organometallic complexes | 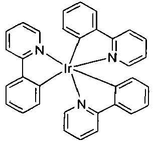 | Inorg. Chem. 40, 1704 (2001) |
| | and its derivatives | |
| | 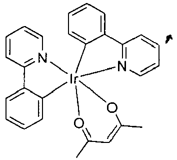 | US20020034656 |
| | 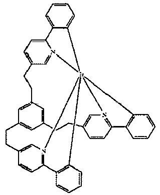 | US7332232 |
| | 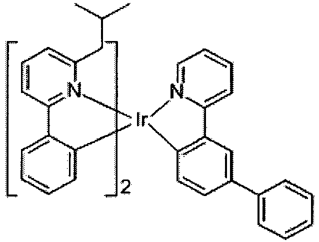 | US20090108737 |
| | 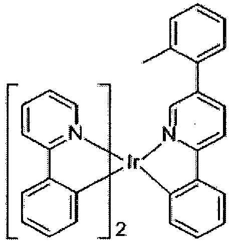 | WO2010028151 |
| | 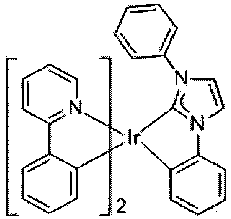 | EP1841834B |
| | 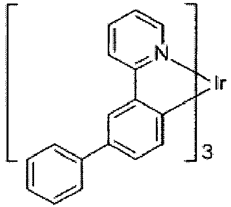 | US20060127696 |
| | 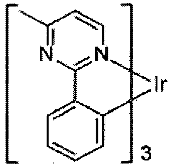 | US20090039776 |
| | 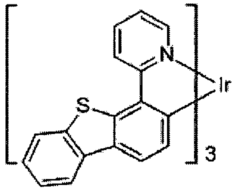 | US6921915 |
| | 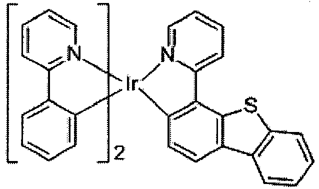 | US20100244004 |
| | 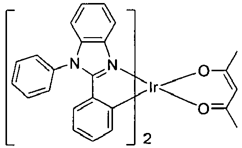 | US6687266 |
| | 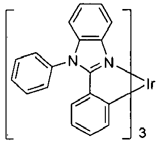 | Chem. Mater. 16, 2480 (2004) |
| | 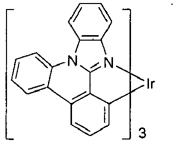 | US20070190359 |
| | 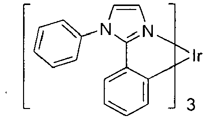 | US 20060008670 JP2007123392 |
| | 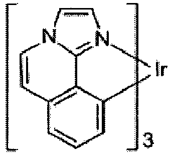 | WO2010086089, WO2011044988 |
| | 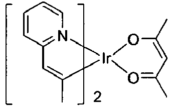 | Adv. Mater. 16, 2003 (2004) |
| | 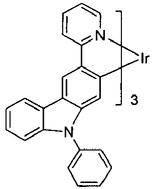 | Angew. Chem. Int. Ed. 2006,45,7800 |
| | 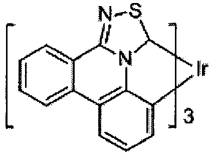 | WO2009050290 |
| | 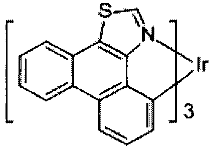 | US20090165846 |
| | 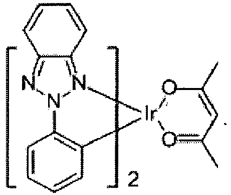 | US20080015355 |
| | 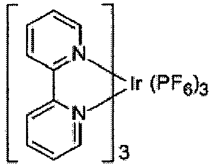 | US20010015432 |
| | 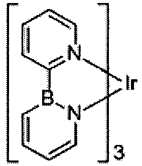 | US20100295032 |
| Monomer for polymeric metal organometallic compounds | 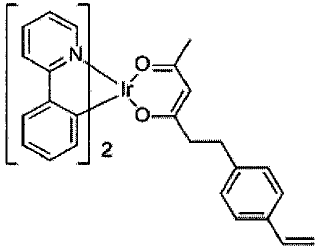 | US7250226, US7396598 |
| Pt(II) organometallic complexes, including polydentated ligands | 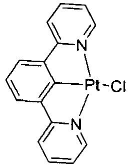 | Appl. Phys. Lett. 86, 153505 (2005) |
| | 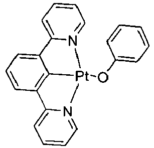 | Appl. Phys. Lett. 86, 153505 (2005) |
| | 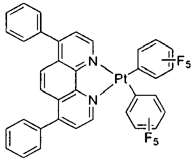 | Chem. Lett. 34, 592 (2005) |
| | 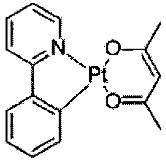 | WO2002015645 |
| | 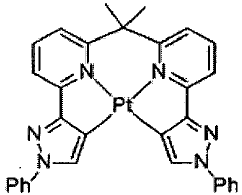 | US20060263635 |
| | 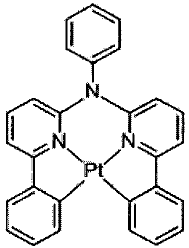 | US20060182992 |
| | | US20070103060 |
| Cu complexes | 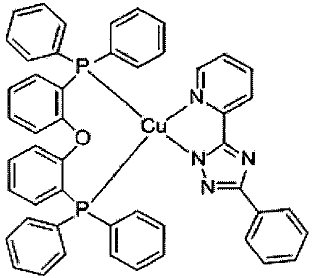 | WO2009000673 |
| | 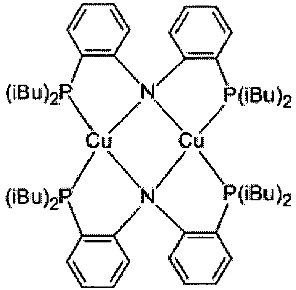 | US20070111026 |
| Gold complexes | 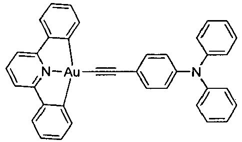 | Chem. Commun. 2906 (2005) |
| Rhenium(III) complexes | 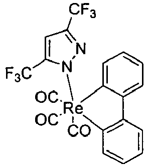 | Inorg. Chem. 42, 1248 (2003) |
| Osmium(II) complexes | 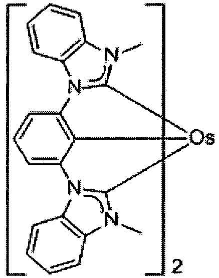 | US7279704 |
| Deuterated organometallic complexes | 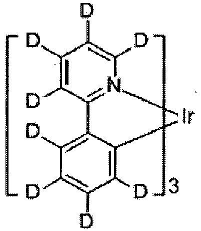 | US20030138657 |
| Organometallic complexes with two or more metal centers | 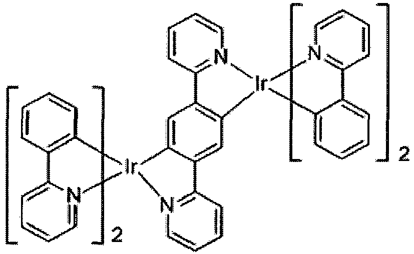 | US20030152802 |
| | 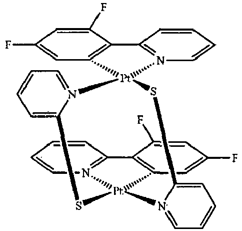 | US7090928 |
| **Blue dopants** | | |
| Iridium(III) organometallic complexes | 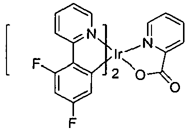 | WO2002002714 |
| | 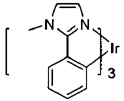 | WO2006009024 |
| | 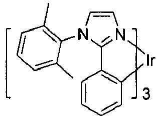 | US20060251923 |
| | | US20110057559 |
| | | US20110204333 |
| | 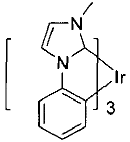 | US7393599, WO2006056418, US20050260441, WO2005019373 |
| | 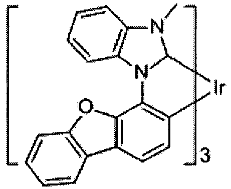 | US7534505 |
| | 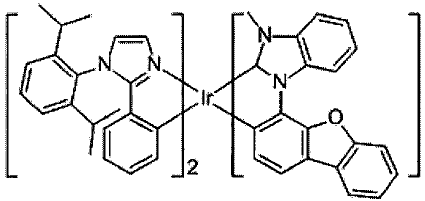 | WO2011051404 |
| | 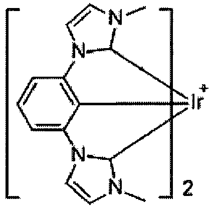 | US7445855 |
| | 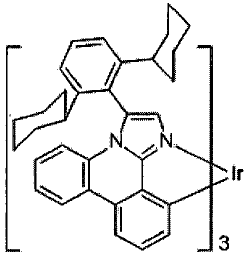 | US20070190359, US20080297033 |
| | | US20100148663 |
| | 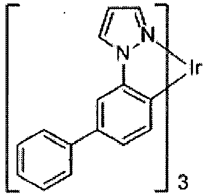 | US7338722 |
| | 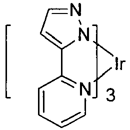 | US20020134984 |
| | 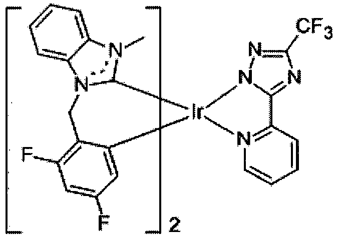 | Angew. Chem. Int. Ed. 47, 4542 (2008) |
| | 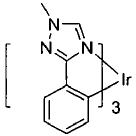 | Chem. Mater. 18, 5119 (2006) |
| | 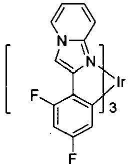 | Inorg. Chem. 46, 4308 (2007) |
| | 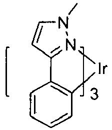 | WO2005123873 |
| | 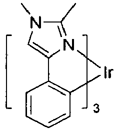 | WO2005123873 |
| | 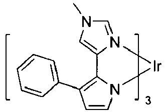 | WO2007004380 |
| | 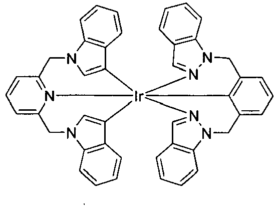 | WO2006082742 |
| Osmium(II) complexes | 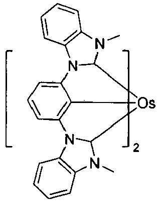 | US7279704 |
| | 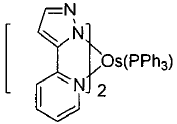 | Organometallics 23, 3745 (2004) |
| Gold complexes | 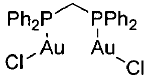 | Appl. Phys. Lett.74,1361 (1999) |
| Platinum(II) complexes | 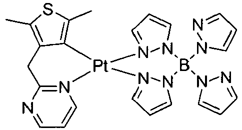 | WO2006098120, WO2006103874 |
| Pt tetradentate complexes with at least one metal-carbene bond | 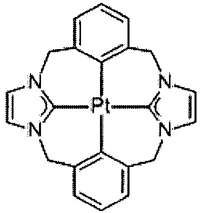 | US7655323 |
| **Exciton/hole blocking layer materials** | | |
| Bathocuprine compounds | 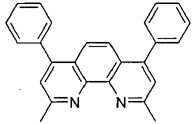 | Appl. Phys. Lett. 75, 4 (1999) |
| (e.g., BCP, BPhen) | | |
| | 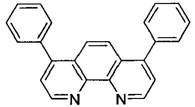 | Appl. Phys. Lett. 79, 449 (2001) |
| Metal 8-hydroxyquinolates | 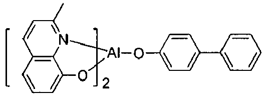 | Appl. Phys. Lett. 81, 162 (2002) |
| (e.g., BAlq) | | |
| 5-member ring electron deficient heterocycles such as triazole, oxadiazole, imidazole, benzoimidazole | 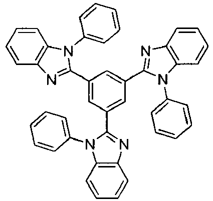 | Appl. Phys. Lett. 81, 162 (2002) |
| Triphenylene compounds | 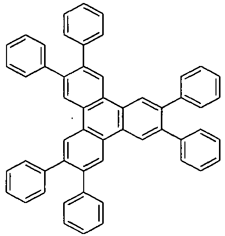 | US20050025993 |
| Fluorinated aromatic compounds | 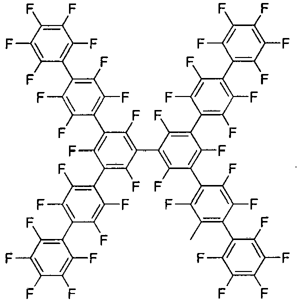 | Appl. Phys. Lett. 79, 156 (2001) |
| Phenothiazine-S-oxide | 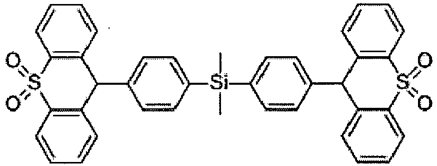 | WO2008132085 |
| Silylated five-membered nitrogen, oxygen, sulfur or phosphorus dibenzoheterocycles | 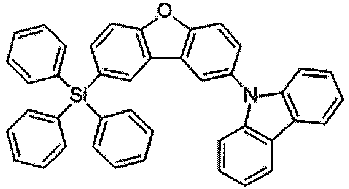 | WO2010079051 |
| Aza-carbazoles | 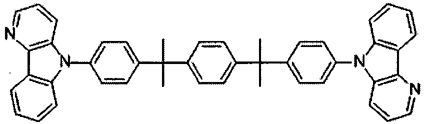 | US20060121308 |
| **Electron transporting materials** | | |
| Anthracene-benzoimidazole compounds | 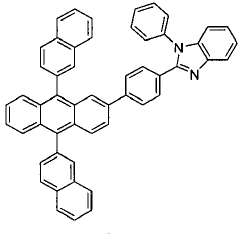 | WO2003060956 |
| | 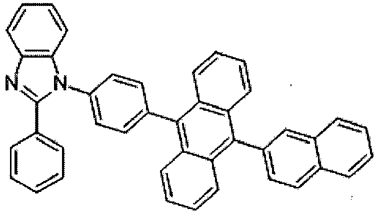 | US20090179554 |
| Aza triphenylene derivatives | 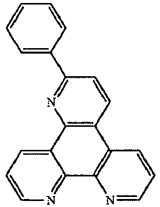 | US20090115316 |
| Anthracene-benzothiazole compounds | 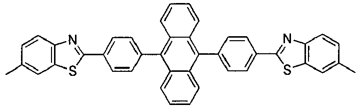 | Appl. Phys. Lett. 89, 063504 (2006) |
| Metal 8-hydroxyquinolates (e.g., Alq₃, Zrq₄) | 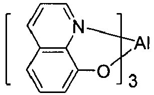 | Appl. Phys. Lett. 51, 913 (1987) US7230107 |
| Metal hydroxybenzoquinolates | 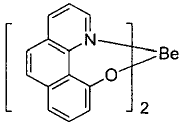 | Chem. Lett. 5, 905 (1993) |
| Bathocuprine compounds such as BCP, BPhen, etc | 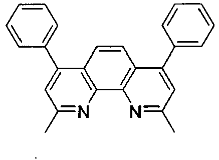 | Appl. Phys. Lett. 91, 263503 (2007) |
| | 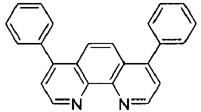 | Appl. Phys. Lett. 79, 449 (2001) |
| 5-member ring electron deficient heterocycles | 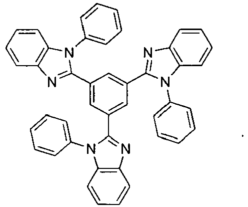 | Appl. Phys. Lett. 74, 865 (1999) |
| (e.g.,triazole, oxadiazole, imidazole, benzoimidazole) | | |
| | 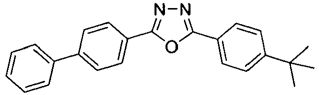 | Appl. Phys. Lett. 55, 1489 (1989) |
| | 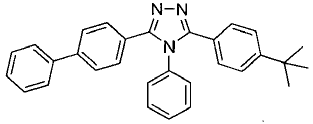 | Jpn. J. Apply. Phys. 32, L917 (1993) |
| Silole compounds | 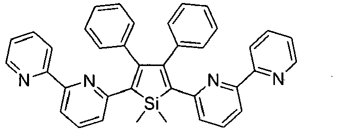 | Org. Electron. 4, 113 (2003) |
| Arylborane compounds | 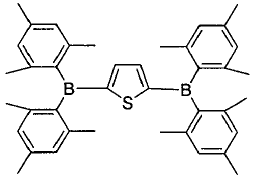 | J. Am. Chem. Soc. 120, 9714 (1998) |
| Fluorinated aromatic compounds | 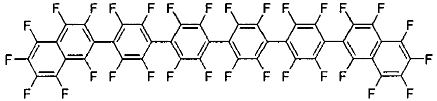 | J. Am. Chem. Soc. 122, 1832 (2000) |
| Fullerene (e.g., C60) | 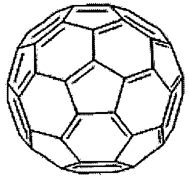 | US20090101870 |
| Triazine complexes | 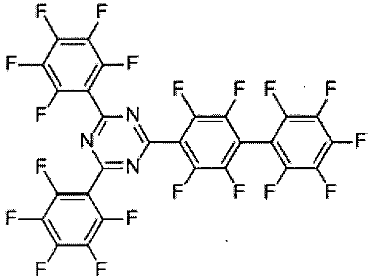 | US20040036077 |
| Zn (N^N) complexes | 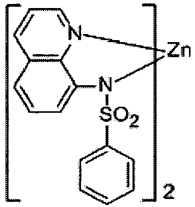 | US6528187 |

### EXPERIMENTAL

### Example 1 - Compound Synthesis

The compounds of formula I can be made by any suitable method. In some embodiments, such compounds can be made in a manner consistent with the reaction scheme shown on the following:

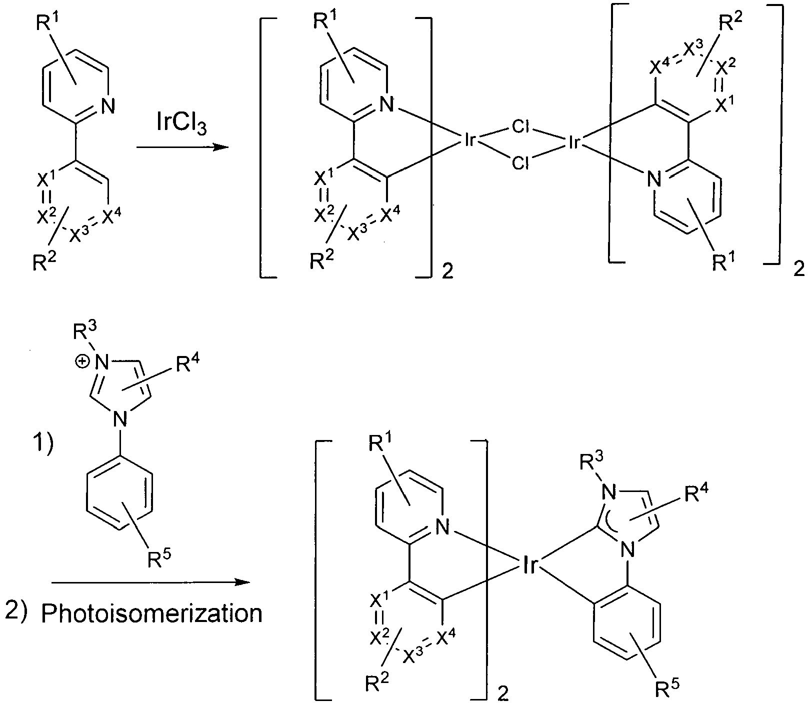

Such methods may be modified as applied to the synthesis of any particular compound, based on the knowledge of persons of skill in the art.

### Example 2 - Computational Examples

Density Functional Theory (DFT) calculations were performed for certain example compounds and comparative compounds. The results are shown in Table 1, below. Geometry optimization calculations were performed using the Gaussian 09 software package using the B3LYP hybrid functional and CEP-31g effective core potential basis set.

**Table 1 Calculation results of selected compounds of formula I and comparative compounds**

| Compound | HOMO (eV) | LUMO (eV) | Gap (eV) | S1 (nm) | T1 (nm) |
|---|---|---|---|---|---|
| 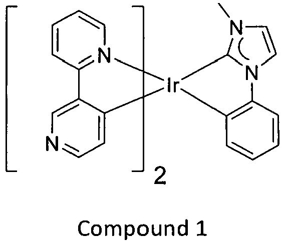 | -5.43 | -1.75 | 3.67 | 419 | 469 |
| 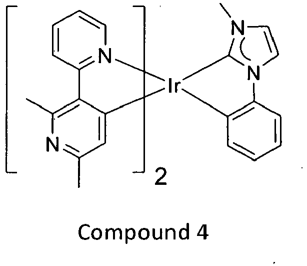 | -5.33 | -1.62 | 3.72 | 415 | 470 |
| 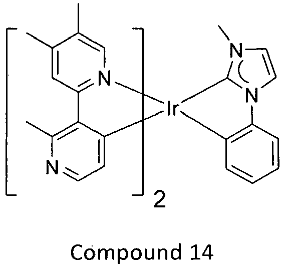 | -5.29 | -1.51 | 3.78 | 407 | 467 |
| 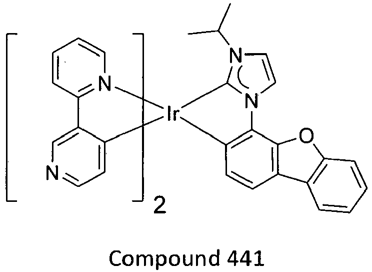 | -5.38 | -1.78 | 3.61 | 422 | 468 |
| 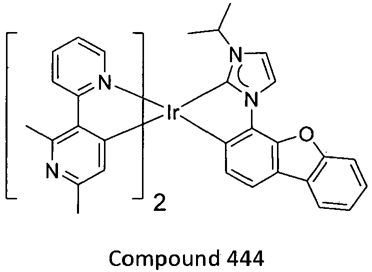 | -5.31 | -1.64 | 3.66 | 417 | 469 |
| 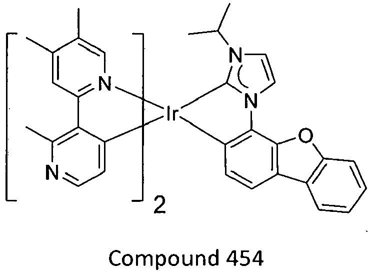 | -5.27 | -1.54 | 3.73 | 407 | 465 |
| 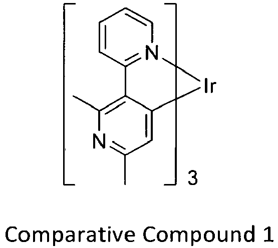 | -5.61 | -1.74 | 3.88 | 399 | 464 |
| 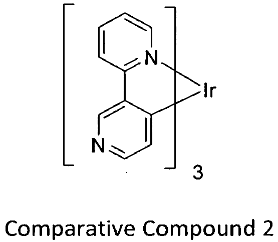 | -5.81 | -1.89 | 3.91 | 395 | 462 |

The selected compounds of formula I were compared against Comparative Compounds 1 and 2. A carbene ligand is present in the compounds of formula I. From the calculation results, the compounds of formual I have slightly red-shifted color compared to the comparative compounds. However, the calculated emission maximum of the compounds of formula I remains blue.

Another noticeable difference is the HOMO of the compounds of formula I. The comparative compounds have a HOMO level deeper than -5.60 eV, while the HOMO level of the compounds of Formula I is significantly shallower. The deep HOMO of the comparative compounds makes them inefficient hole traps. As a result, devices using the comparative compounds as emitters usually need highly confined structures, which can reduce the device stability. The shallow HOMO energy level of the inventive compounds makes them efficient hole traps in devices. It will in turn enable stable devices.

It is understood that the various embodiments described herein are by way of example only, and are not intended to limit the scope of the invention.

Preferred embodiments of the invention are as follows:
1. A compound having the formula Ir(L_{A})ₙ(L_{B})₃₋ₙ, having the structure: 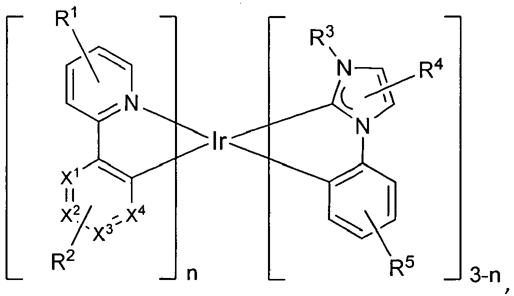 Formula I;
   wherein R¹ and R⁵ each independently represent mono, di, tri, or tetra-substitution, or no substitution;
   wherein R² represents up to tri-substitution, or no substitution;
   wherein R⁴ represents mono, or di-substitution, or no substitution;
   wherein X¹, X², X³, and X⁴ are each independently C or N;
   wherein at least one of X¹, X², X³, and X⁴ is N;
   wherein any adjacent substituents of R¹, R², R³, R⁴, and R⁵ are optionally linked together to form a ring;
   wherein each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
   wherein n is either 1 or 2.
2. The compound of paragraph 1, wherein n is 1.
3. The compound of paragraph 1, wherein n is 2.
4. The compound of any one of paragraphs 1 to 3, wherein the compound has the formula: 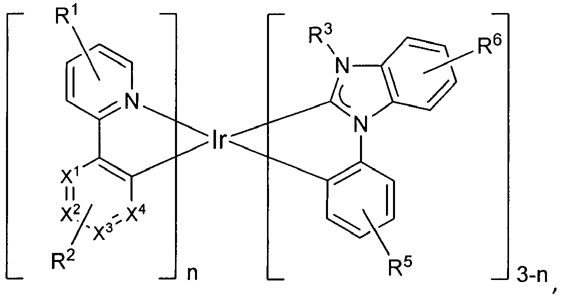 Formula II;
   wherein R⁶ represents mono, di, tri, or tetra-substitution, or no substitution;
   wherein any adjacent substitutions of R⁶ are optionally linked together to form a ring; and
   wherein each R⁶ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.
5. The compound of paragraph 4, wherein only one of X¹, X², X³, and X⁴ is N.
6. The compound of paragraph 5, wherein X² is N.
7. The compound of any one of paragraphs 1 to 6, wherein R¹ is selected from the group consisting of hydrogen, deuterium, alkyl, cycloalkyl, and combinations thereof.
8. The compound of any one of paragraphs 1 to 7, wherein R² is selected from the group consisting of hydrogen, deuterium, halide, alkyl, cycloalkyl, nitrile, and combinations thereof.
9. The compound of any one of paragraphs 1 to 8, wherein R³ is alkyl or cycloalkyl.
10. The compound of any one of paragraphs 1 to 8, wherein R³ is aryl or substituted aryl.
11. The compound of any one of paragraphs 1 to 8, wherein R³ is selected from the group consisting of: ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, and cyclohexyl, wherein each group is optionally partially or fully deuterated.
12. The compound of paragraph 1, wherein the compound is selected from the group consisting of: 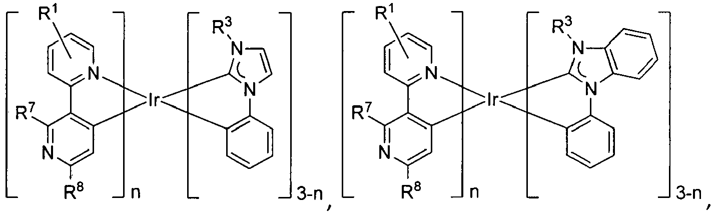 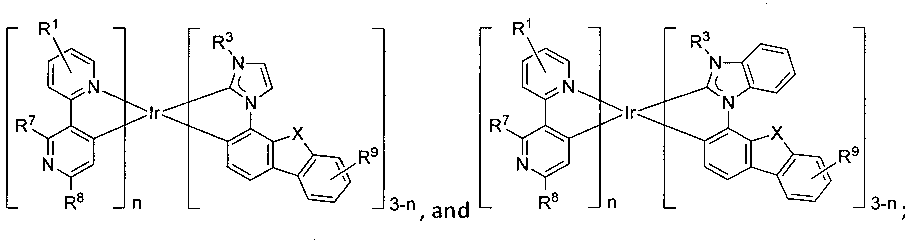
   wherein R⁹ represents mono, di, tri, or tetra-substitution, or no substitution;
   wherein each R⁷, R⁸, and R⁹ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
   wherein X is O or S.
13. The compound of any one of paragraphs 1 to 4 and 9 to 11, wherein L_{A} is selected from the group consisting of: 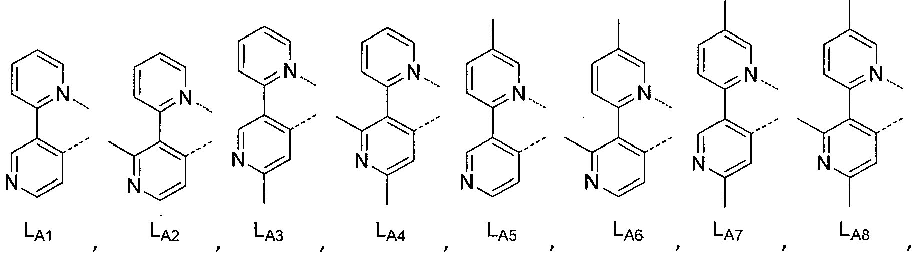 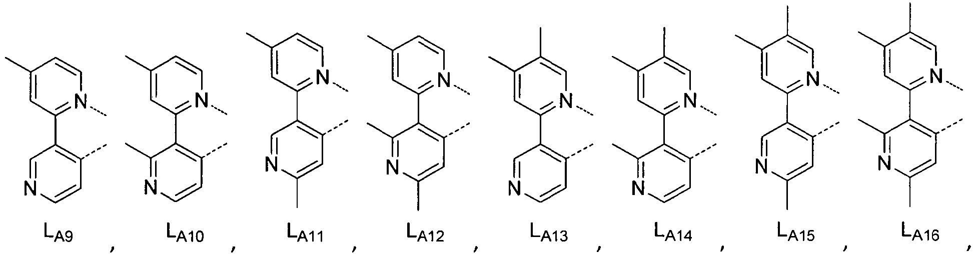 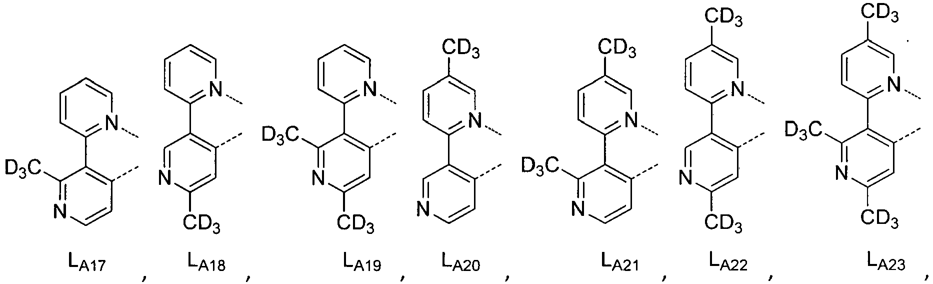 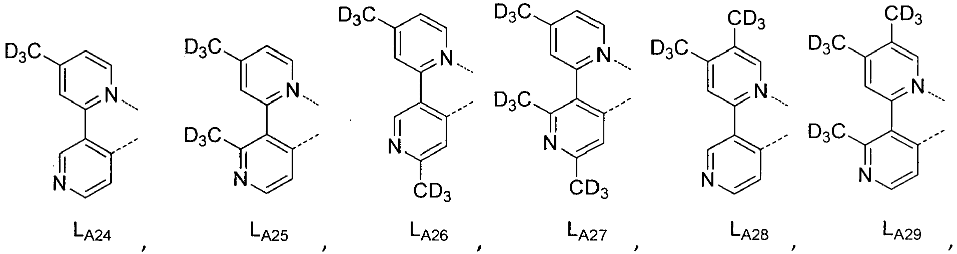 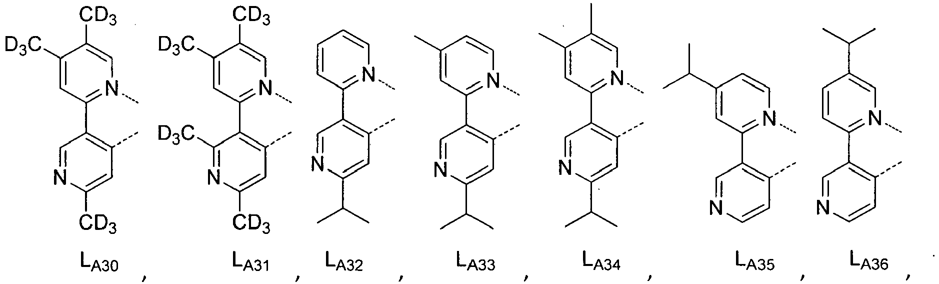 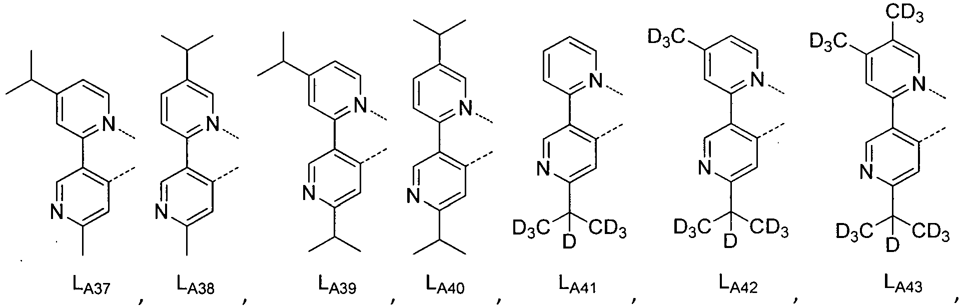 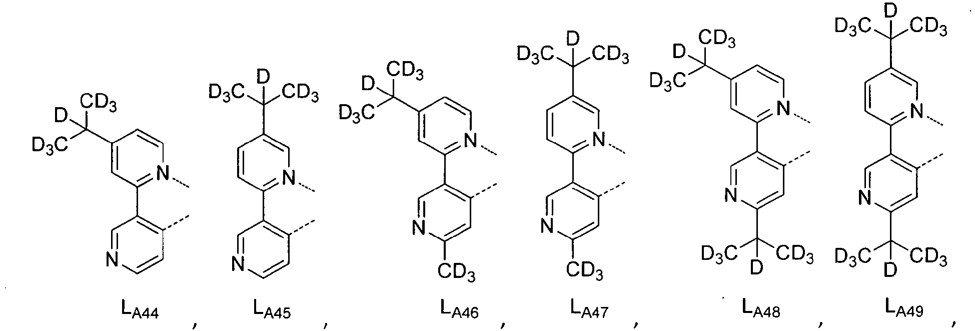 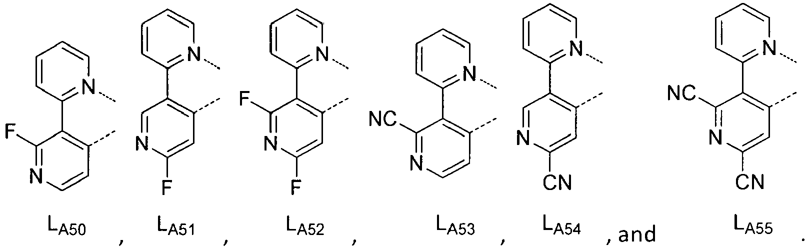
14. The compound of any one of paragraphs 1 to 8, wherein L_{B} is selected from the group consisting of: 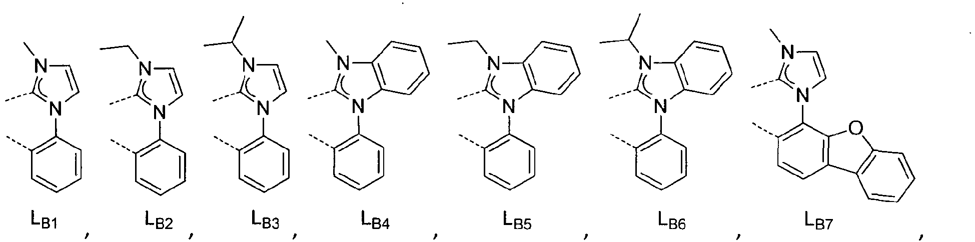 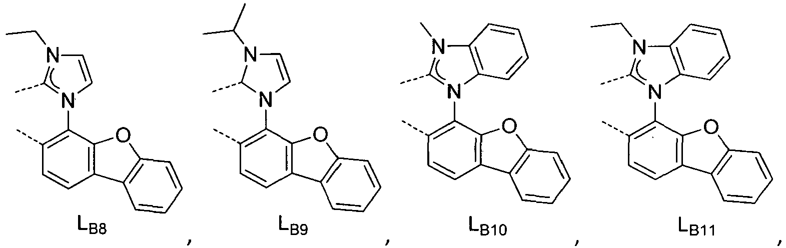 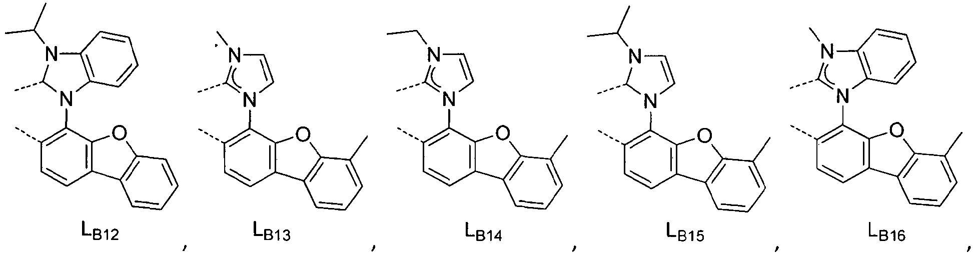 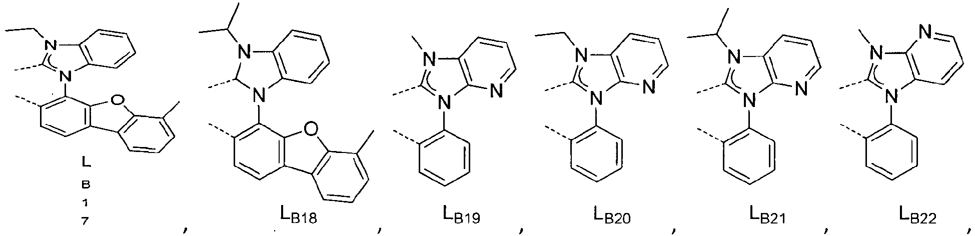 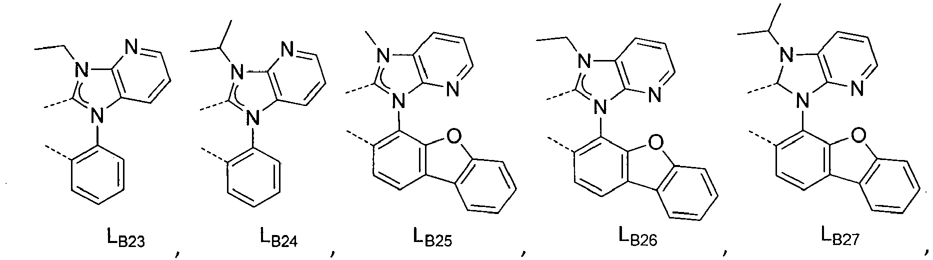 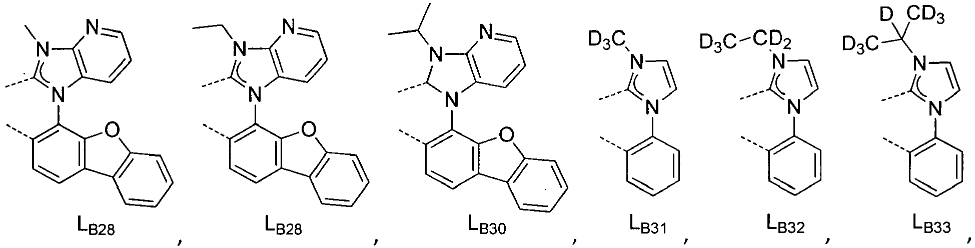 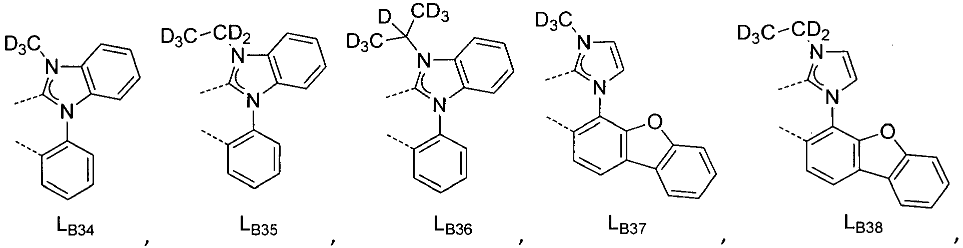 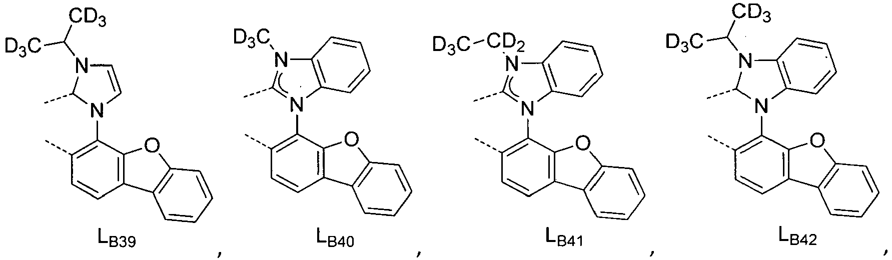 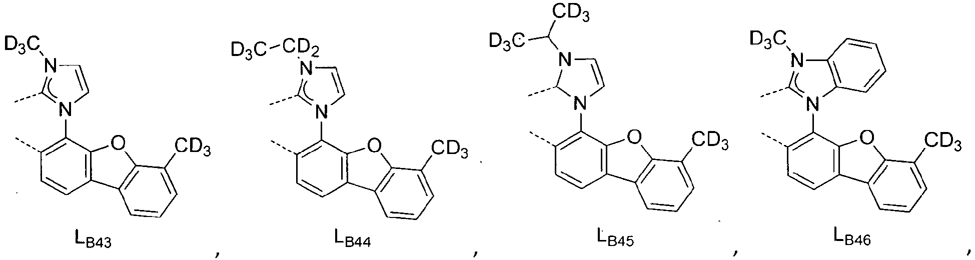 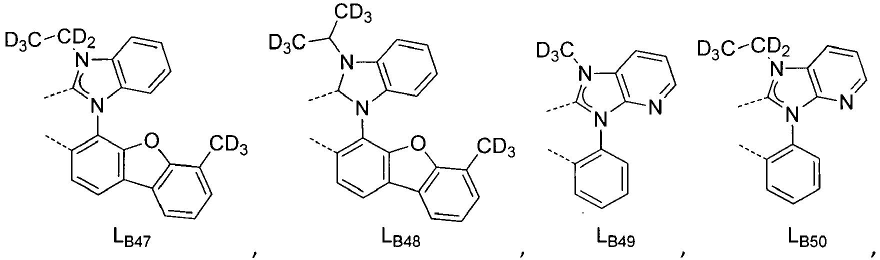 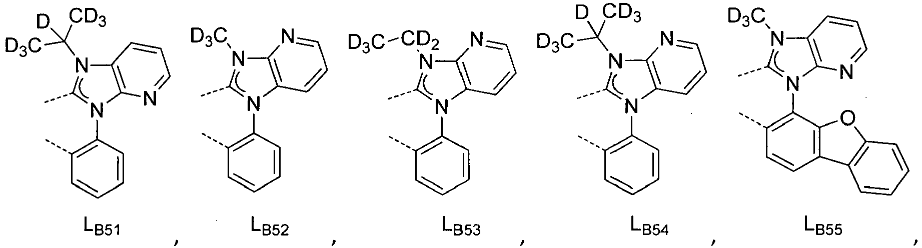 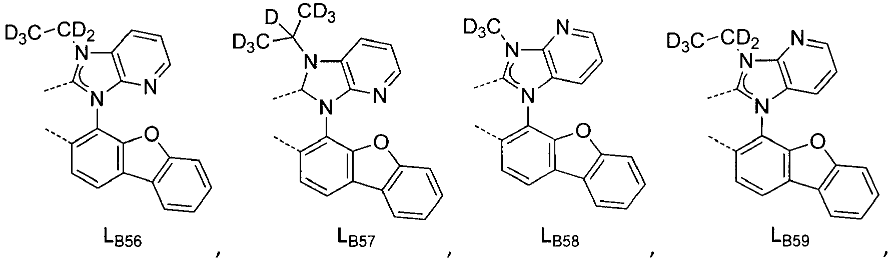 and 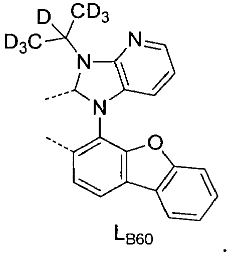
15. The compound of paragraph 14, wherein L_{A} is selected from the group consisting of: 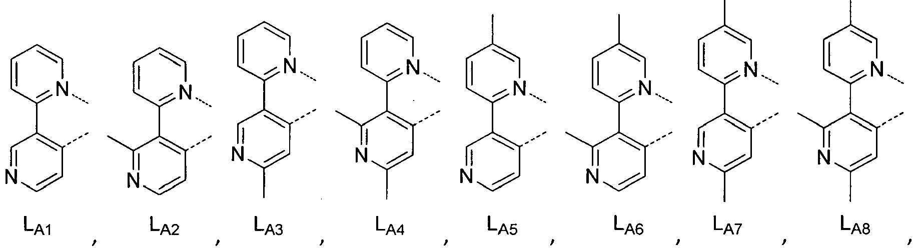 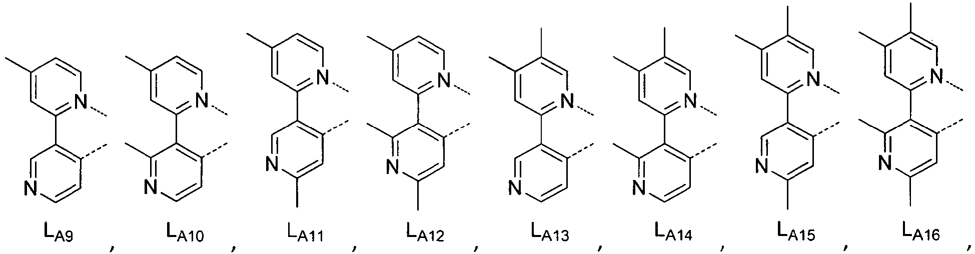 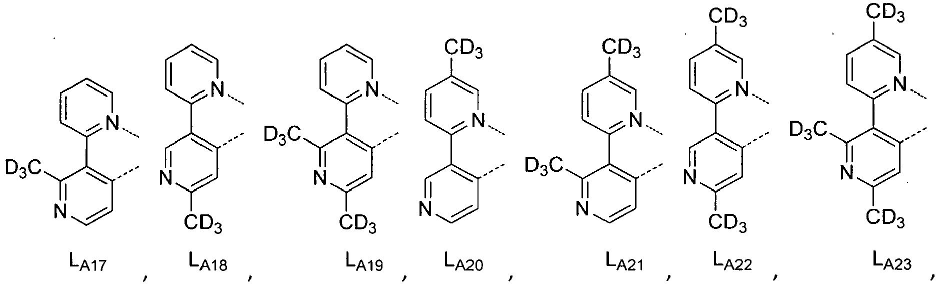 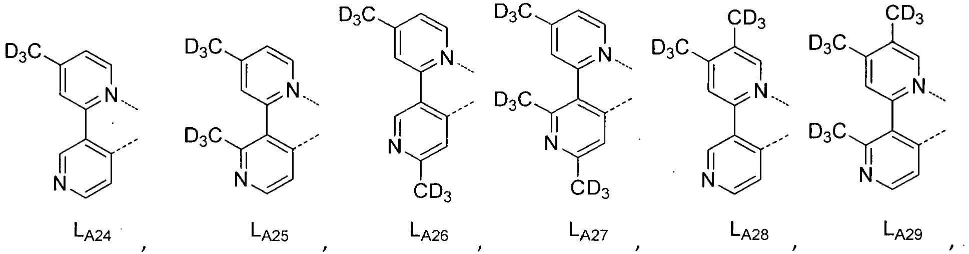 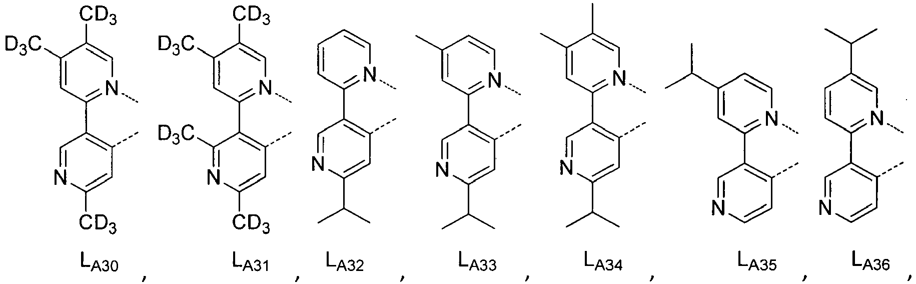 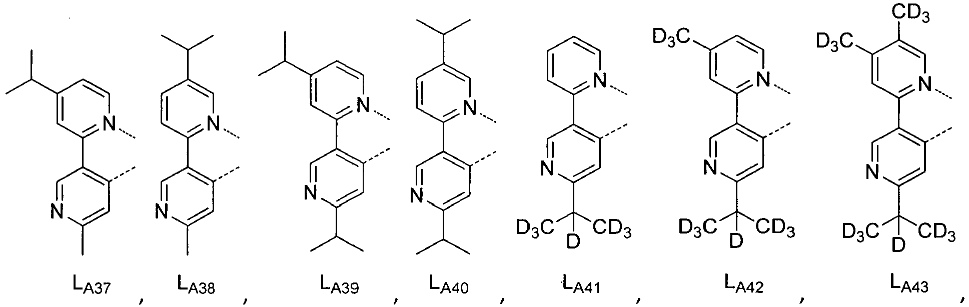 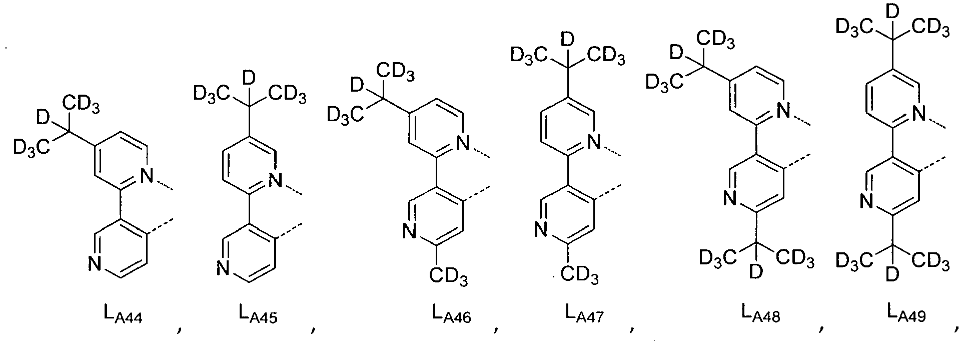 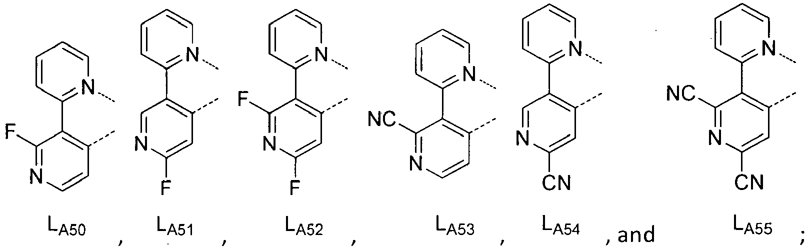
   wherein n is 2; and
   wherein the compound is selected from the group consisting of compound 1 to compound 3300, wherein each Compound x has the formula Ir(L_{A*k*})₂(L_{B*j*}), wherein x = 55*j* + *k* - 55, wherein k is an integer from 1 to 55, and *j* is an integer from 1 to 60.
16. A first device comprising a first organic light emitting device, the first organic light emitting device comprising:
   an anode;
   a cathode; and
   an organic layer, disposed between the anode and the cathode, comprising a compound having the formula Ir(L_{A})ₙ(L_{B})₃₋ₙ, having the structure: 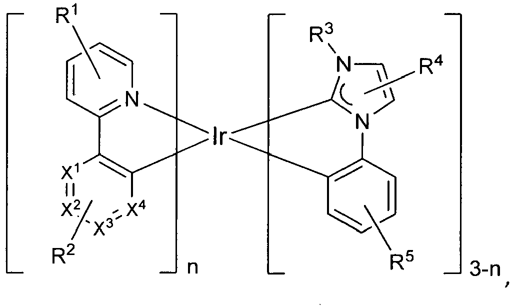 Formula I;
      wherein R¹ and R⁵ each independently represent mono, di, tri, or tetra-substitution, or no substitution;
      wherein R² represents up to tri-substitution, or no substitution;
      wherein R⁴ represents mono, or di-substitution, or no substitution;
      wherein X¹, X², X³, and X⁴ are each independently C or N;
      wherein at least one of X¹, X², X³, and X⁴ is N;
      wherein any adjacent substituents of R¹, R², R³, R⁴, and R⁵ are optionally linked together to form a ring;
      wherein each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, cyano, and combinations thereof; and
      wherein n is either 1 or 2.
17. The first device of paragraph 16, wherein the first device is selected from the group consisting of a consumer product, an electronic component module, an organic light-emitting device, and a lighting panel.
18. The first device of paragraph 16 or 17, wherein the organic layer is an emissive layer and the compound is an emissive dopant or a non-emissive dopant.
19. The first device of any one of paragraphs 16 to 18, wherein the organic layer further comprises a host, wherein the host comprises a triphenylene containing benzo-fused thiophene or benzo-fused furan;
   wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ-Ar₁, or no substitution;
   wherein n is from 1 to 10; and
   wherein Ar₁ and Ar₂ are independently selected from the group consisting of benzene, biphenyl, naphthalene, triphenylene, carbazole, and heteroaromatic analogs thereof.
20. The first device of any one of paragraphs 16 to 19, wherein the organic layer further comprises a host, wherein the host comprises at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene.
21. The first device of any one of paragraphs 16 to 20, wherein the organic layer further comprises a host and the host is selected from the group consisting of : 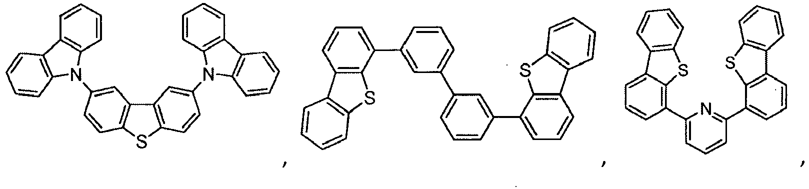 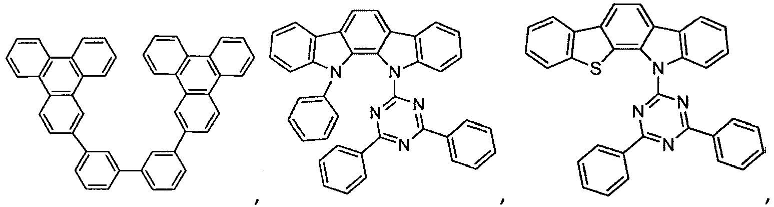 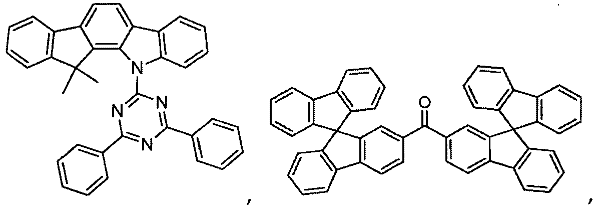 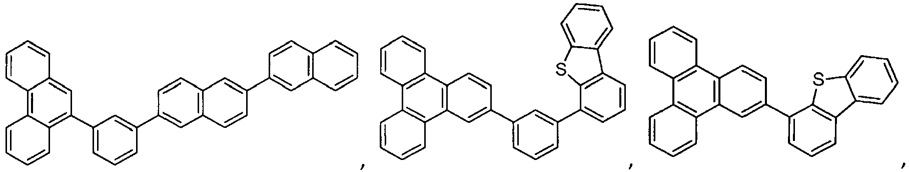 and combinations thereof.
22. The first device of any one of paragraphs 16 to 21, wherein the organic layer further comprises a host and the host comprises a metal complex.
23. A formulation comprising a compound having the formula Ir(L_{A})ₙ(L_{B})₃₋ₙ, having the structure: 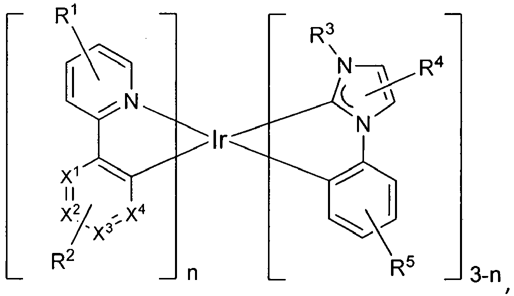 Formula I;
   wherein R¹ and R⁵ each independently represent mono, di, tri, or tetra-substitution, or no substitution;
   wherein R² represents up to tri-substitution, or no substitution;
   wherein R⁴ represents mono, or di-substitution, or no substitution;
   wherein X¹, X², X³, and X⁴ are each independently C or N;
   wherein at least one of X¹, X², X³, and X⁴ is N;
   wherein any adjacent substituents of R¹, R², R³, R⁴, and R⁵ are optionally linked together to form a ring;
   wherein each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, cyano, and combinations thereof; and
   wherein n is either 1 or 2.

## Claims

1. A compound having the formula Ir(L_{A})ₙ(L_{B})₃₋ₙ, having the structure: 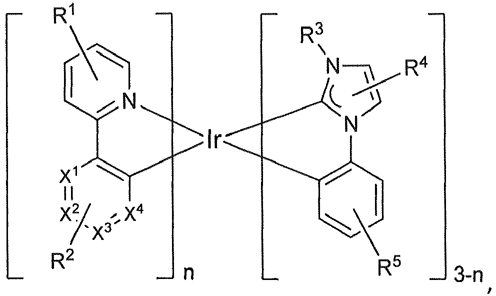 Formula I;
wherein R¹ and R⁵ each independently represent mono, di, tri, or tetra-substitution, or no substitution;
wherein R² represents up to tri-substitution, or no substitution;
wherein R⁴ represents mono, or di-substitution, or no substitution;
wherein X¹, X², X³, and X⁴ are each independently C or N;
wherein any adjacent substituents of R¹, R², R³, R⁴, and R⁵ are optionally linked together to form a ring;
wherein each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is either 1 or 2;
**characterised in that** at least one of X¹, X², X³, and X⁴ is N.

2. The compound of claim 1, wherein n is 1.

3. The compound of claim 1, wherein n is 2.

4. The compound of any one of claims 1 to 3, wherein the compound has the formula: 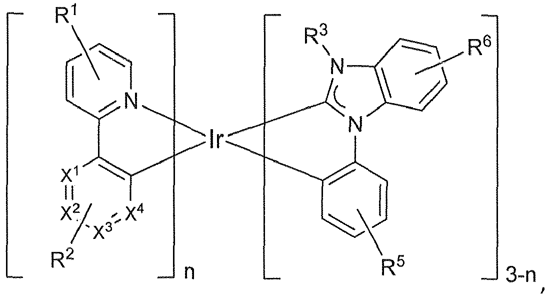 Formula II;
wherein R⁶ represents mono, di, tri, or tetra-substitution, or no substitution;
wherein any adjacent substitutions of R⁶ are optionally linked together to form a ring; and
wherein each R⁶ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

5. The compound of claim 4, wherein only one of X¹, X², X³, and X⁴ is N.

6. The compound of any one of claims 1 to 5, wherein R¹ is selected from the group consisting of hydrogen, deuterium, alkyl, cycloalkyl, and combinations thereof.

7. The compound of any one of claims 1 to 6, wherein R² is selected from the group consisting of hydrogen, deuterium, halide, alkyl, cycloalkyl, nitrile, and combinations thereof.

8. The compound of any one of claims 1 to 7, wherein R³ is alkyl or cycloalkyl.

9. The compound of any one of claims 1 to 7, wherein R³ is aryl or substituted aryl.

10. The compound of claim 1, wherein the compound is selected from the group consisting of: 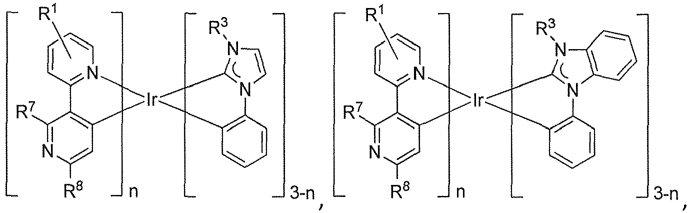 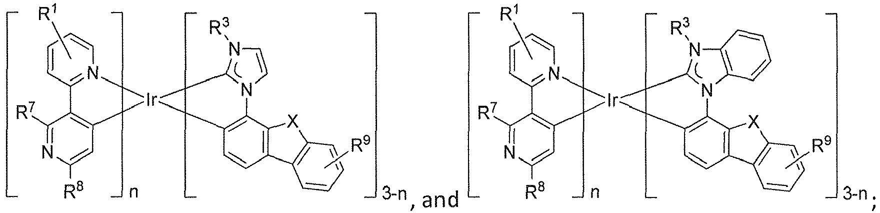
wherein R⁹ represents mono, di, tri, or tetra-substitution, or no substitution;
wherein each R⁷, R⁸, and R⁹ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein X is O or S.

11. The compound of any one of claims 1 to 3, and 8 or 9, wherein L_{A} is selected from the group consisting of:

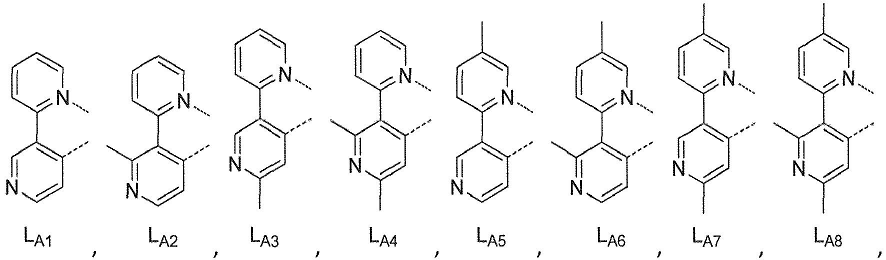

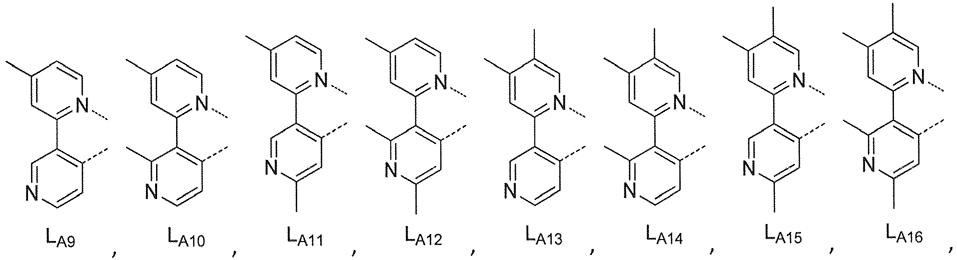

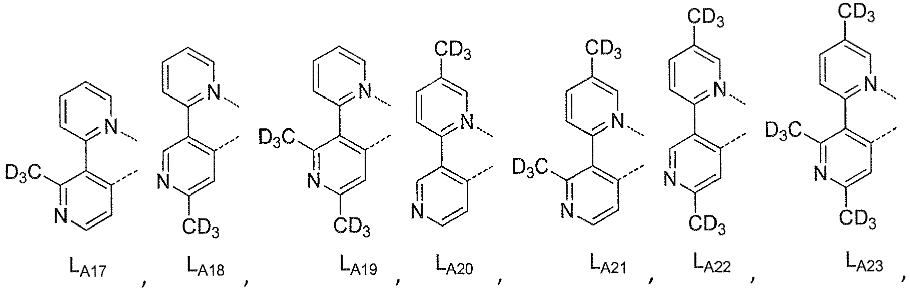

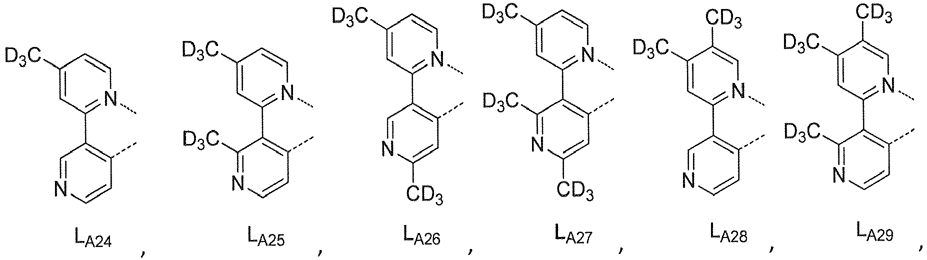

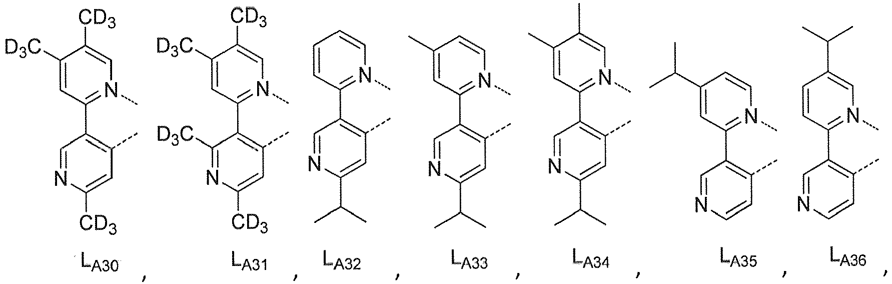

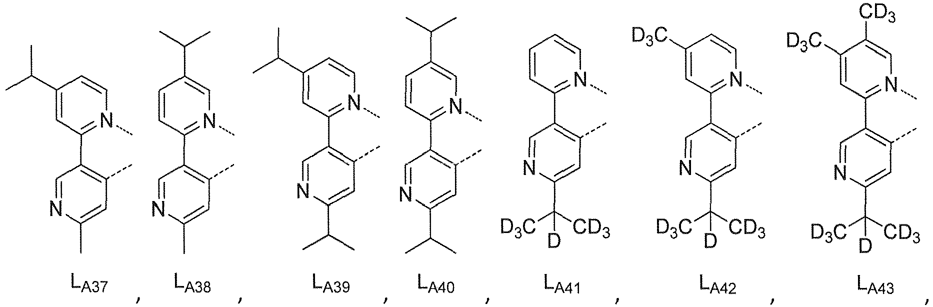

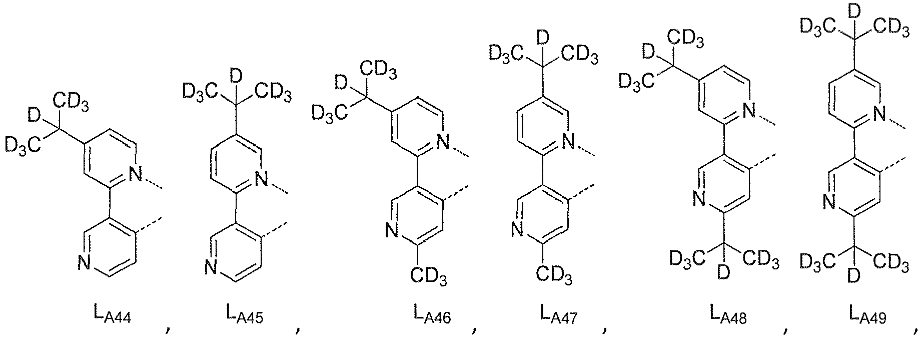

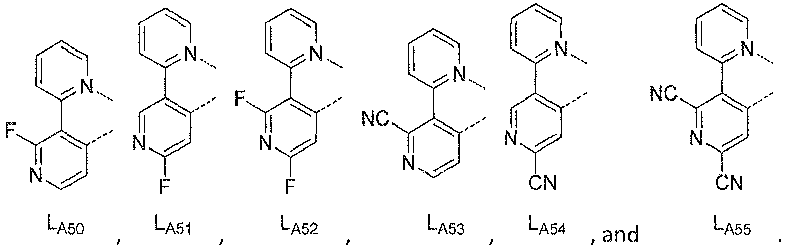

12. The compound of any one of claims 1 to 7, wherein L_{B} is selected from the group consisting of: 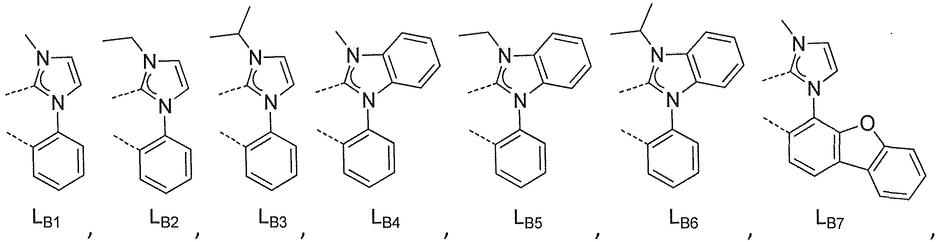 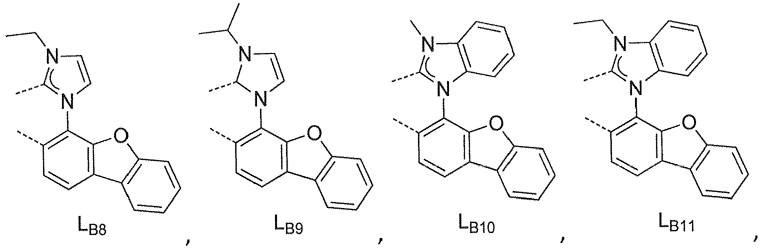 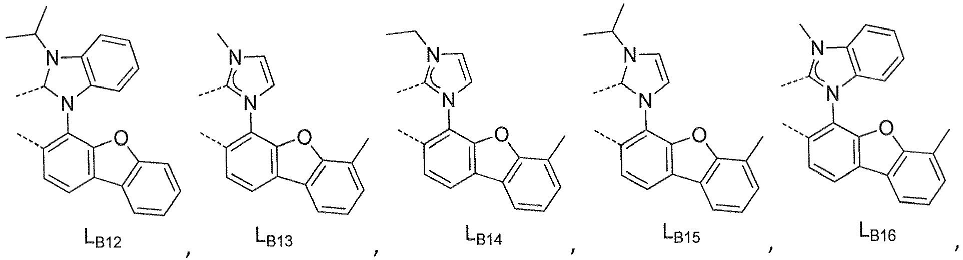 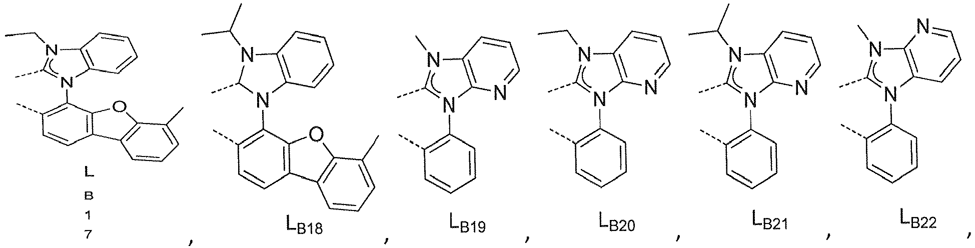 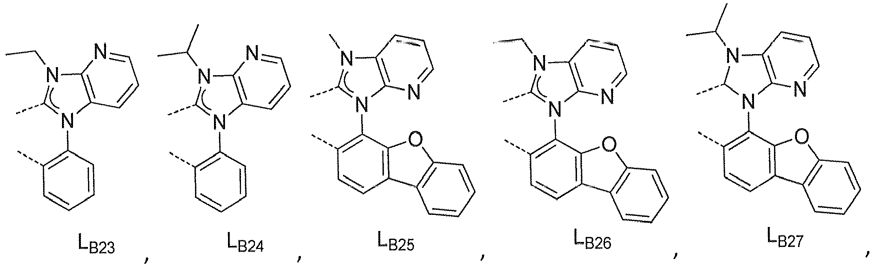 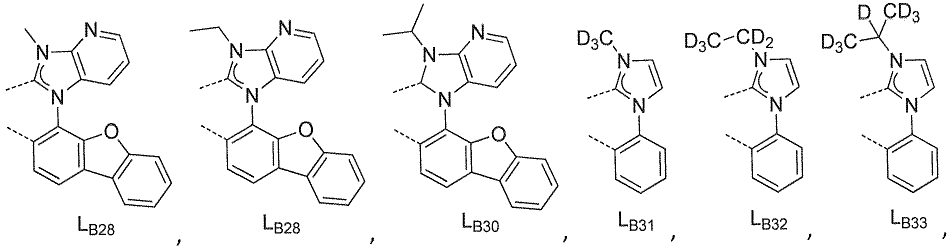 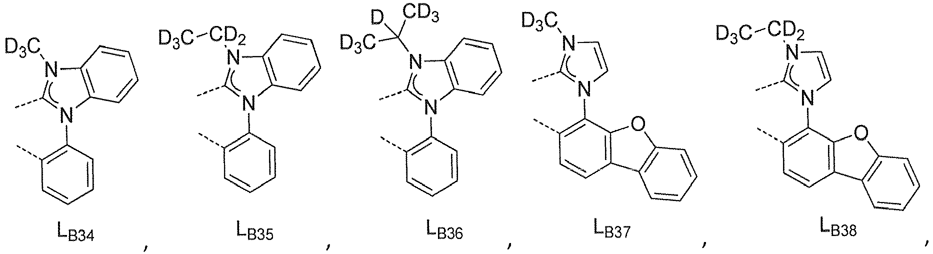 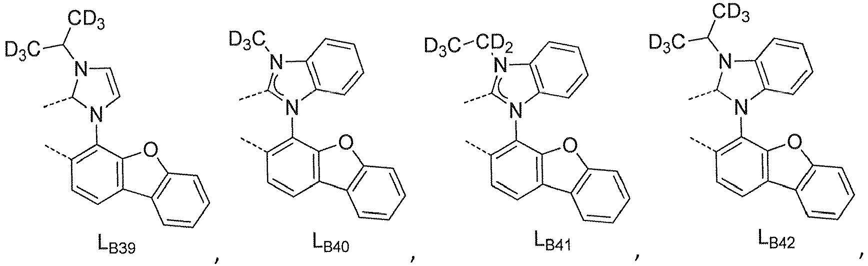 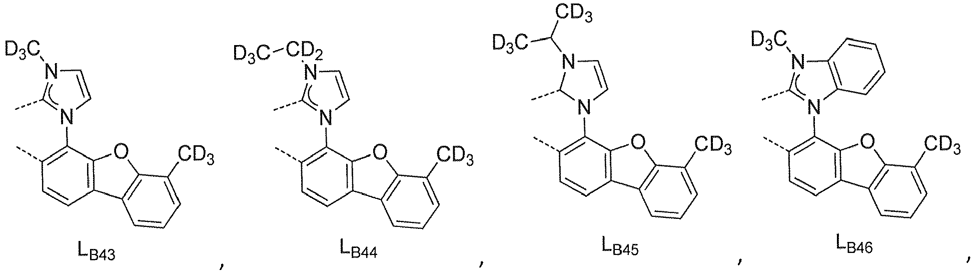 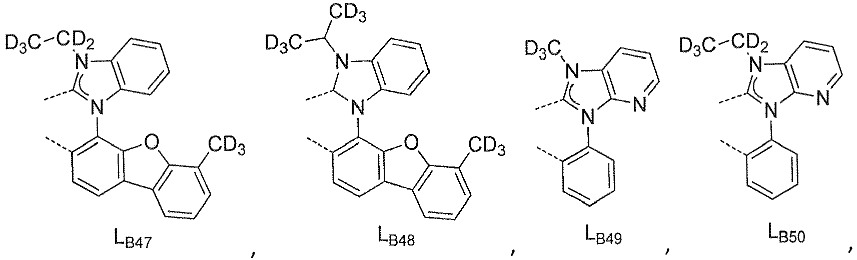 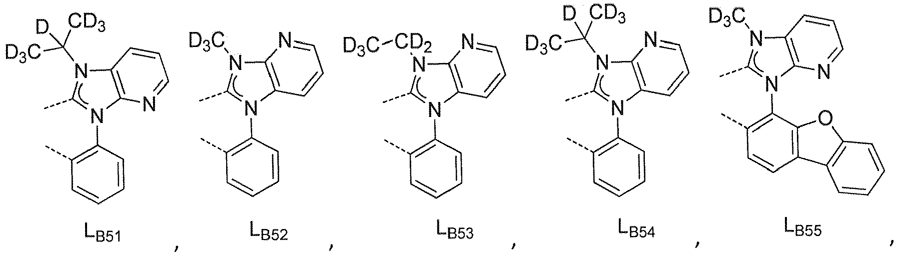 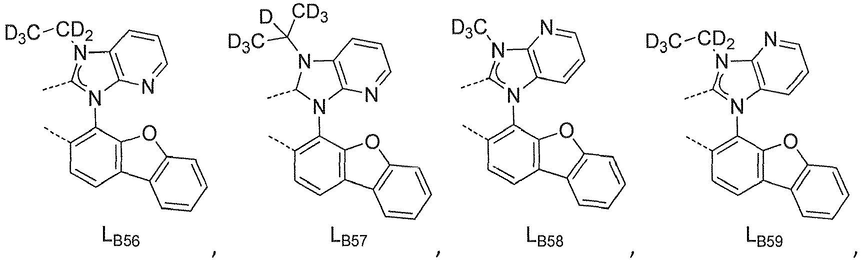 and

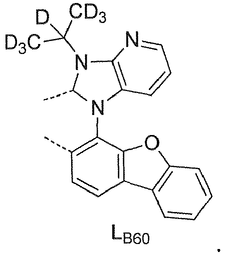

13. The compound of claim 12, wherein L_{A} is selected from the group consisting of: 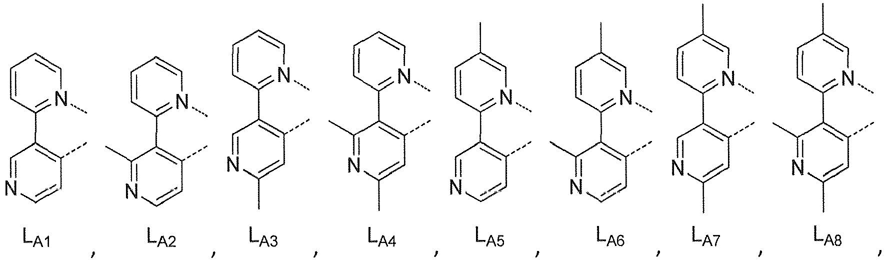 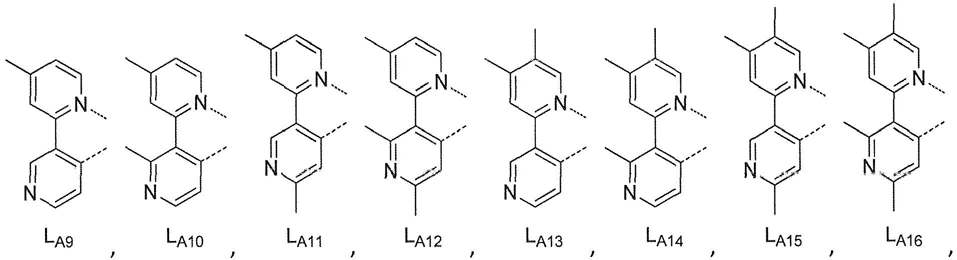 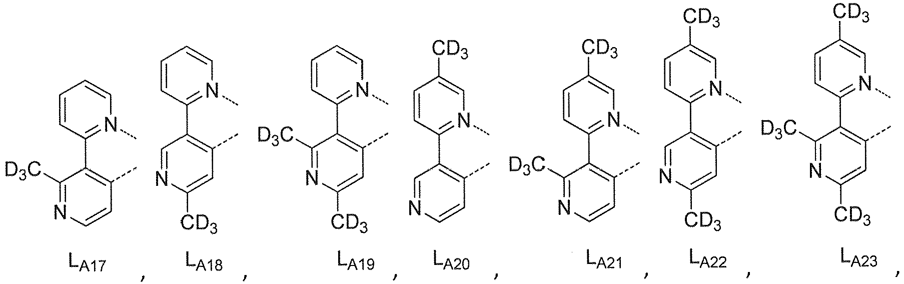 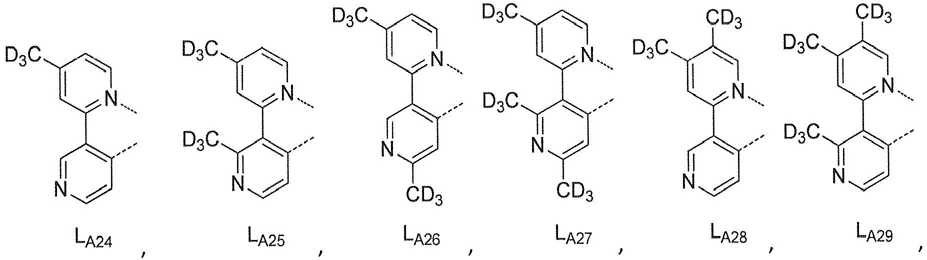 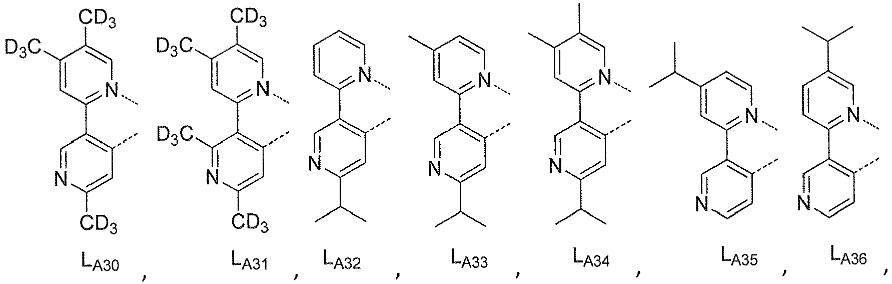 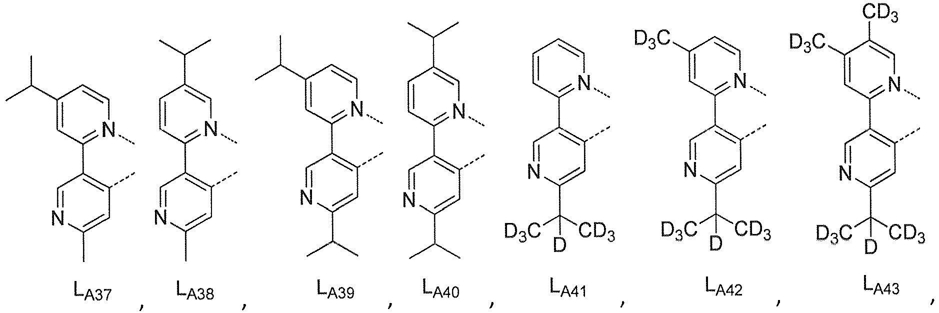 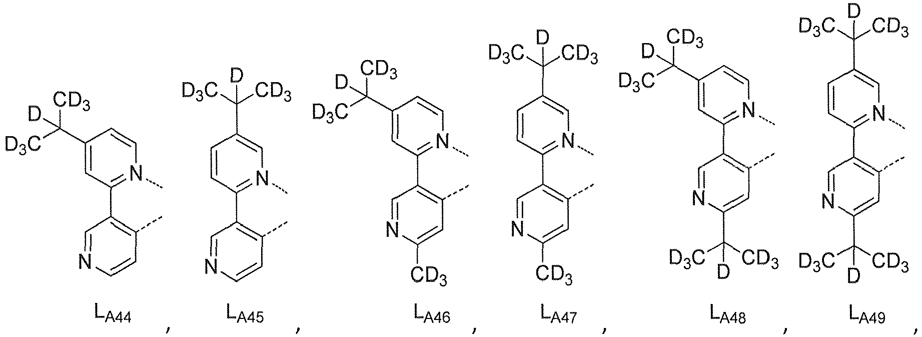 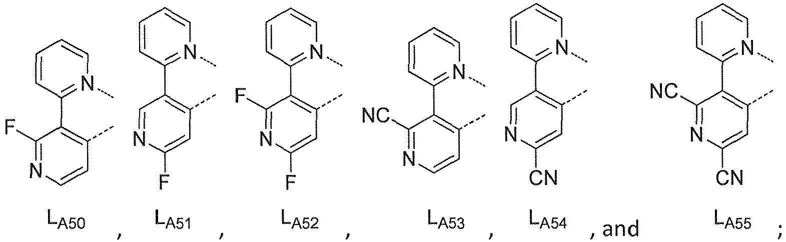
wherein n is 2; and
wherein the compound is selected from the group consisting of compound 1 to compound 3300, wherein for each Compound x has the formula Ir(L_{A*k*})₂(L_{B*j*}), *x* = 55*j* + *k* - 55, wherein *k* is an integer from 1 to 55, and *j* is an integer from 1 to 60.

14. A first device comprising a first organic light emitting device, the first organic light emitting device comprising:
an anode;
a cathode; and
an organic layer, disposed between the anode and the cathode, comprising a compound having the formula Ir(L_{A})ₙ(L_{B})₃₋ₙ, having the structure: 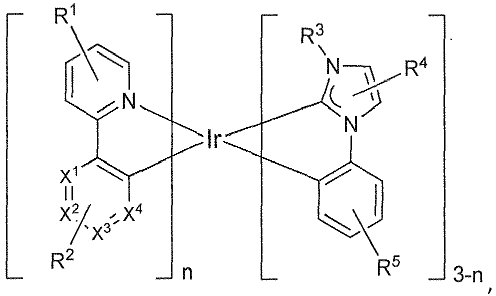 Formula I;
wherein R¹ and R⁵ each independently represent mono, di, tri, or tetra-substitution, or no substitution;
wherein R² represents up to tri-substitution, or no substitution;
wherein R⁴ represents mono, or di-substitution, or no substitution;
wherein X¹, X², X³, and X⁴ are each independently C or N;
wherein at least one of X¹, X², X³, and X⁴ is N;
wherein any adjacent substituents of R¹, R², R³, R⁴, and R⁵ are optionally linked together to form a ring;
wherein each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, cyano, and combinations thereof; and
wherein n is either 1 or 2.

15. A formulation comprising a compound having the formula Ir(L_{A})ₙ(L_{B})₃₋ₙ, having the structure: 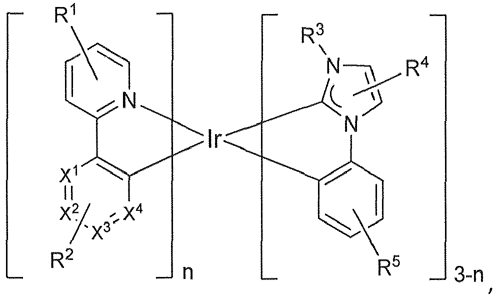 Formula I;
wherein R¹ and R⁵ each independently represent mono, di, tri, or tetra-substitution, or no substitution;
wherein R² represents up to tri-substitution, or no substitution;
wherein R⁴ represents mono, or di-substitution, or no substitution;
wherein X¹, X², X³, and X⁴ are each independently C or N;
wherein at least one of X¹, X², X³, and X⁴ is N;
wherein any adjacent substituents of R¹, R², R³, R⁴, and R⁵ are optionally linked together to form a ring;
wherein each R¹, R², R³, R⁴, and R⁵ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, cyano, and combinations thereof; and
wherein n is either 1 or 2.

## Patentansprüche

1. Verbindung gemäß Formel Ir(L_{A})ₙ(L_{B})₃₋ₙ, mit der folgenden Struktur: 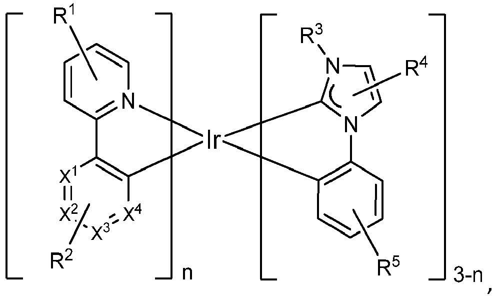 Formel I;
wobei R¹ und R⁵ jeweils unabhängig für mono-, di-, tri-, oder tetra-Substitution, oder keine Substitution stehen;
wobei R² für bis zu tri-Substitution, oder keine Substitution steht;
wobei R⁴ für mono-, oder di-Substitution, oder keine Substitution steht;
wobei X¹, X², X³, und X⁴ jeweils unabhängig C oder N sind;
wobei beliebige benachbarte Substituenten aus R¹, R², R³, R⁴, und R⁵ gegebenenfalls miteinander verbunden sind um einen Ring zu bilden;
wobei jeder von R¹, R², R³, R⁴, und R⁵ unabhängig ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkynyl, Aryl, Heteroaryl, Acyl, Carbonyl, Carbonsäuren, Ester, Nitril, Isonitril, Sulfanyl, Sulfinyl, Sulfonyl, Phosphino, und Kombinationen davon; und
wobei n entweder 1 oder 2 ist;
**dadurch gekennzeichnet, dass** mindestens einer von X¹, X², X³, und X⁴ N ist.

2. Die Verbindung nach Anspruch 1, wobei n gleich 1 ist.

3. Die Verbindung nach Anspruch 1, wobei n gleich 2 ist.

4. Die Verbindung nach einem der Ansprüche 1 bis 3, wobei die Verbindung die folgende Formel aufweist: 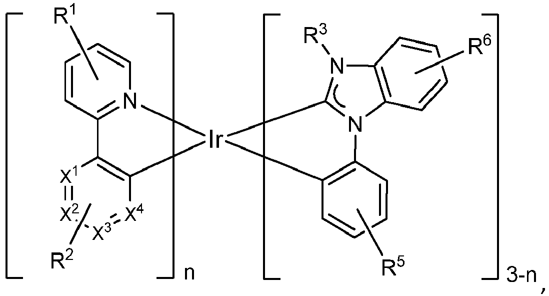 Formel II;
wobei R⁶ für mono-, di-, tri-, oder tetra-Substitution, oder keine Substitution steht;
wobei beliebige benachbarte Substitutionen R⁶ gegebenenfalls miteinander verbunden sind um einen Ring zu bilden; und
wobei jedes R⁶ unabhängig ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkynyl, Aryl, Heteroaryl, Acyl, Carbonyl, Carbonsäuren, Ester, Nitril, Isonitril, Sulfanyl, Sulfinyl, Sulfonyl, Phosphino, und Kombinationen davon.

5. Die Verbindung nach Anspruch 4, wobei nur einer von X¹, X², X³, und X⁴ N ist.

6. Die Verbindung nach einem der Ansprüche 1 bis 5, wobei R¹ ausgewählt ist aus der Gruppe bestehend aus Wasserstoff, Deuterium, Alkyl, Cycloalkyl, und Kombinationen davon.

7. Die Verbindung nach einem der Ansprüche 1 bis 6, wobei R² ausgewählt ist aus der Gruppe bestehend aus Wasserstoff, Deuterium, Halogen, Alkyl, Cycloalkyl, Nitril, und Kombinationen davon.

8. Die Verbindung nach einem der Ansprüche 1 bis 7, wobei R³ Alkyl oder Cycloalkyl ist.

9. Die Verbindung nach einem der Ansprüche 1 bis 7, wobei R³ Aryl oder substituiertes Aryl ist.

10. Die Verbindung nach Anspruch 1, wobei die Verbindung ausgewählt ist aus der Gruppe bestehend aus: 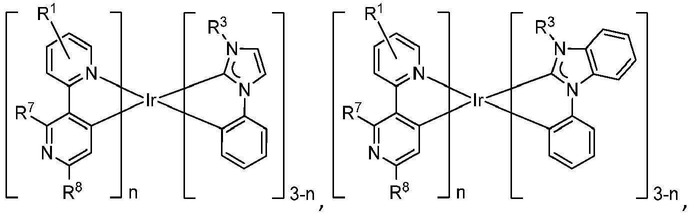 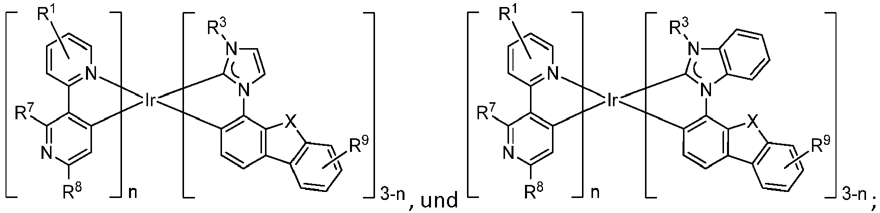
wobei R⁹ für mono-, di-, tri-, oder tetra-Substitution, oder keine Substitution steht;
wobei jedes R⁷, R⁸, und R⁹ unabhängig ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkynyl, Aryl, Heteroaryl, Acyl, Carbonyl, Carbonsäuren, Ester, Nitril, Isonitril, Sulfanyl, Sulfinyl, Sulfonyl, Phosphino, und Kombinationen davon; und
wobei X O oder S ist.

11. Die Verbindung nach einem der Ansprüche 1 bis 3, und 8 oder 9, wobei L_{A} ausgewählt ist aus der Gruppe bestehend aus:

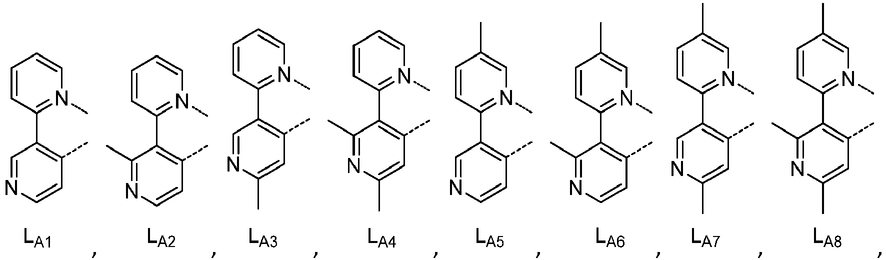

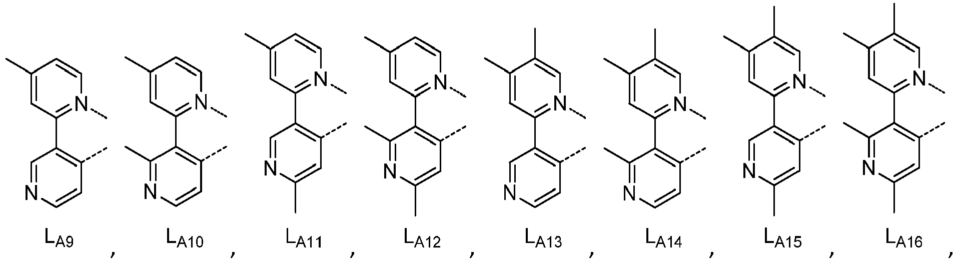

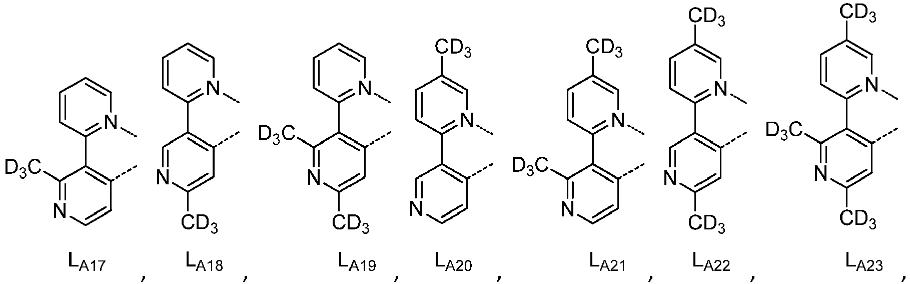

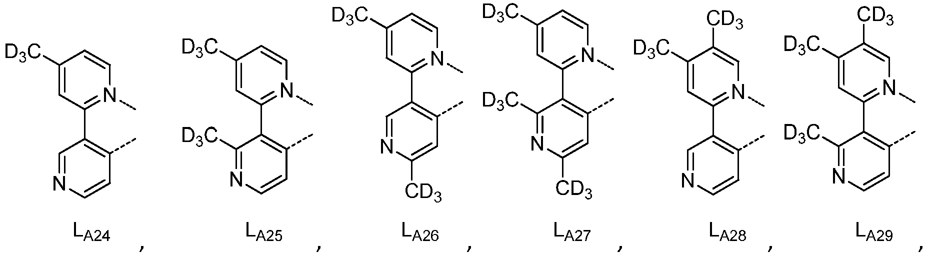

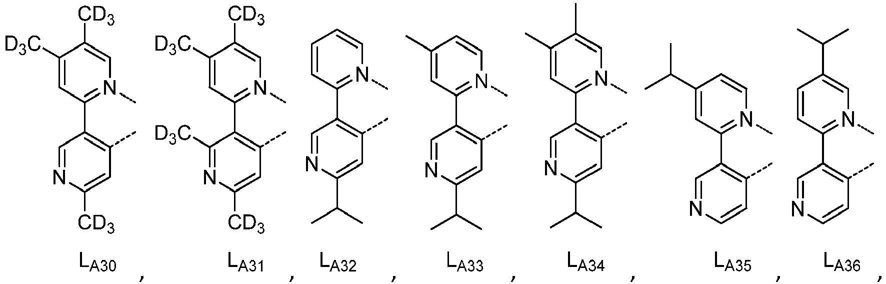

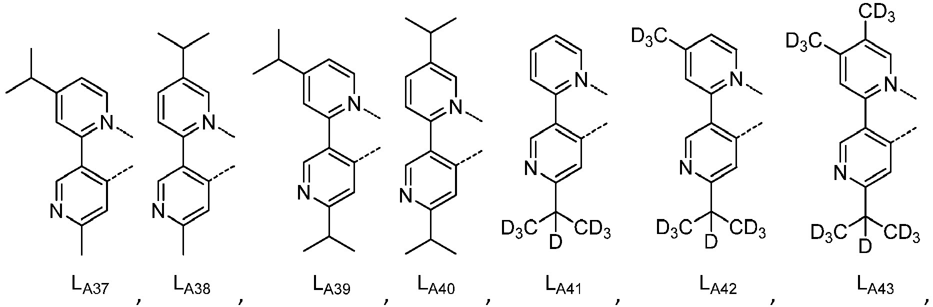

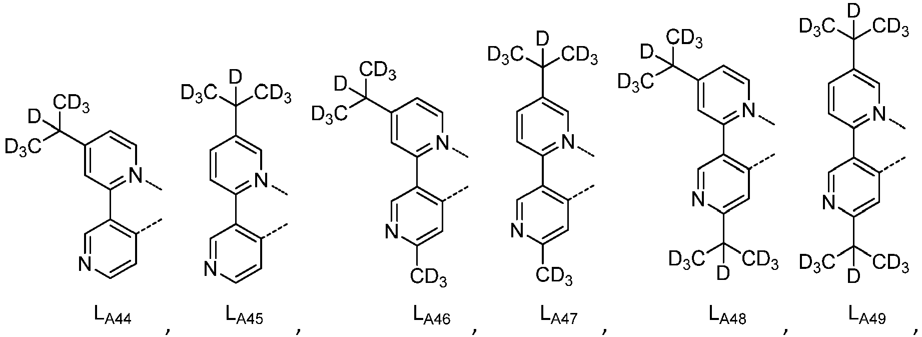

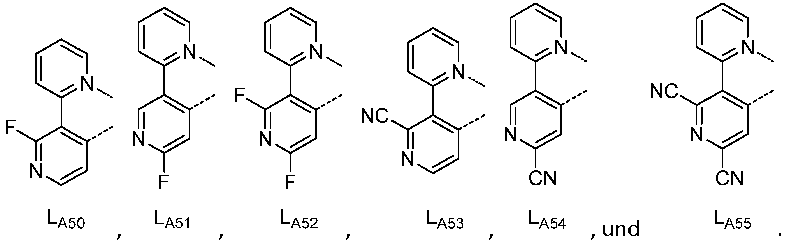

12. Die Verbindung nach einem der Ansprüche 1 bis 7, wobei L_{B} ausgewählt ist aus der Gruppe bestehend aus: 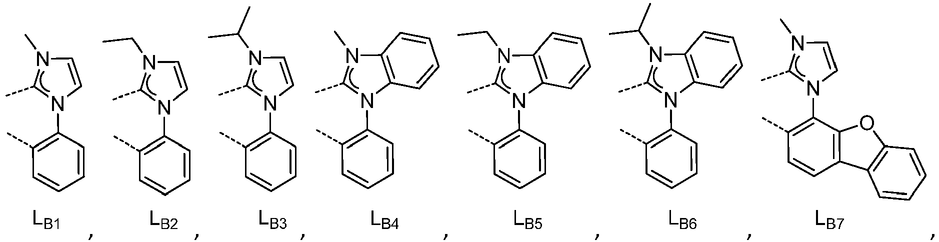 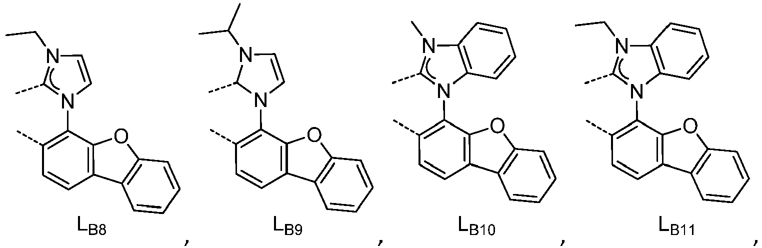 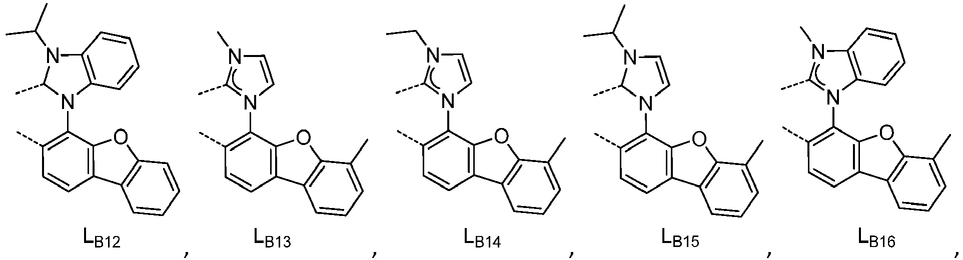 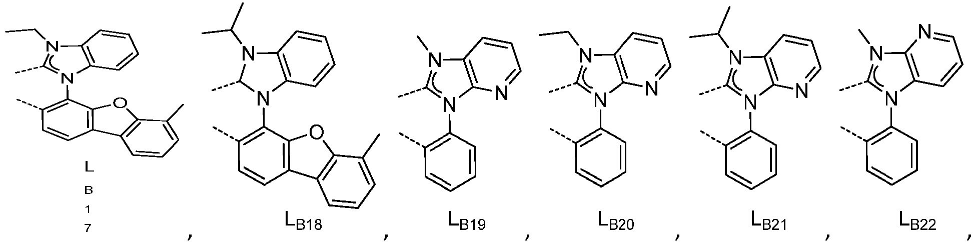 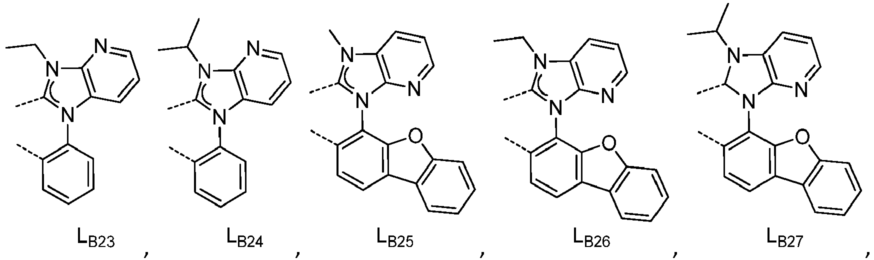 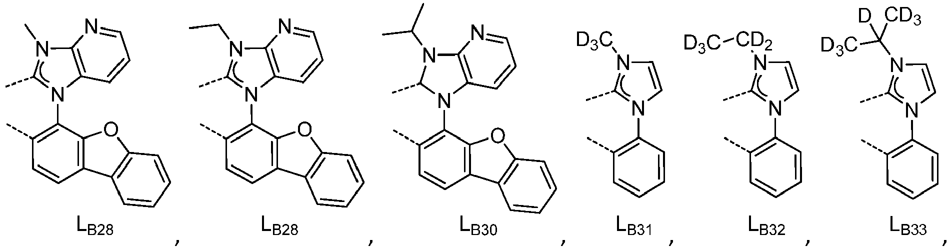 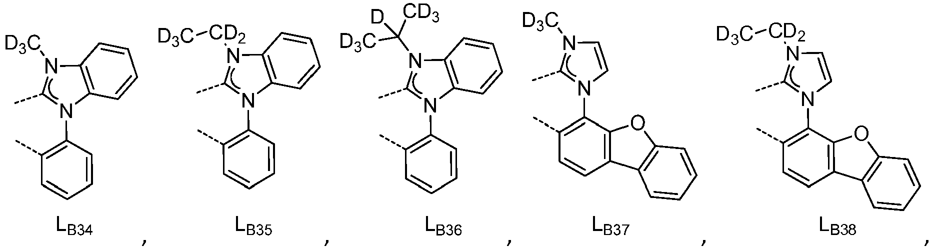 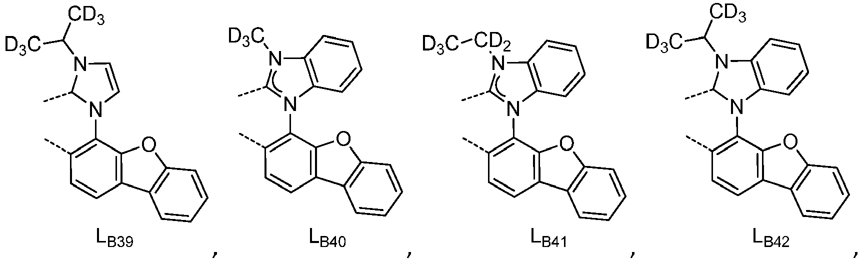 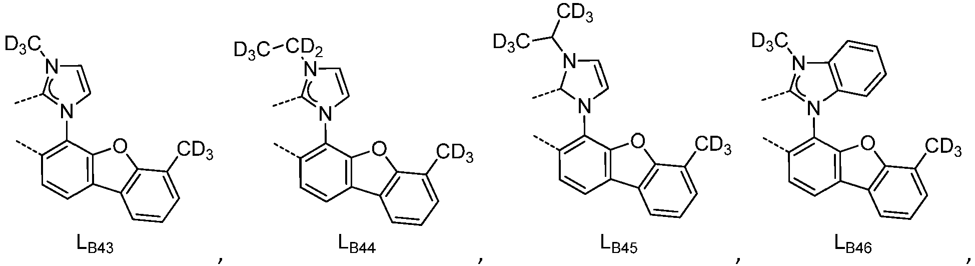 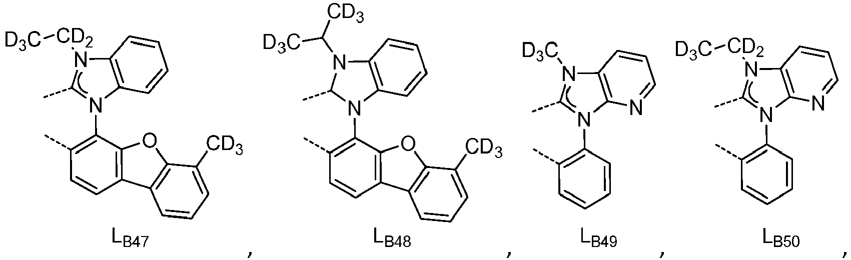 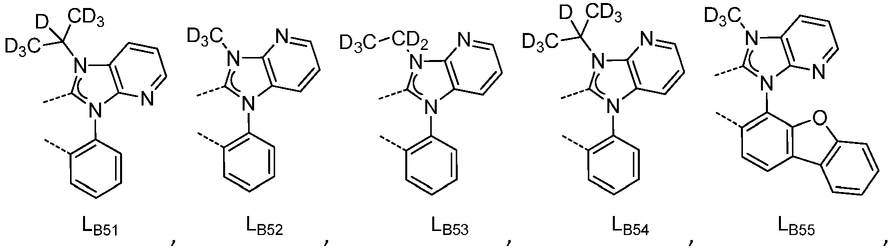 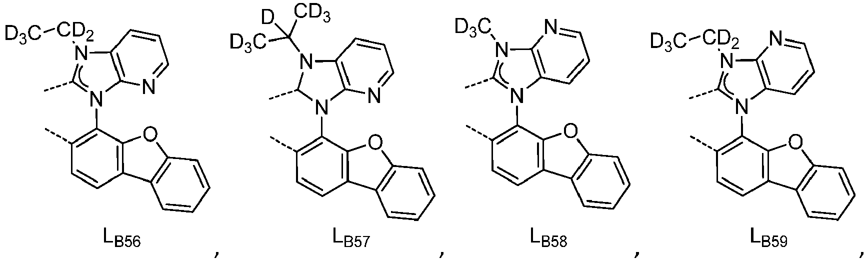 und

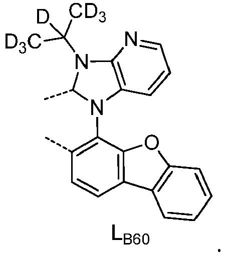

13. Die Verbindung nach Anspruch 12, wobei L_{A} ausgewählt ist aus der Gruppe bestehend aus: 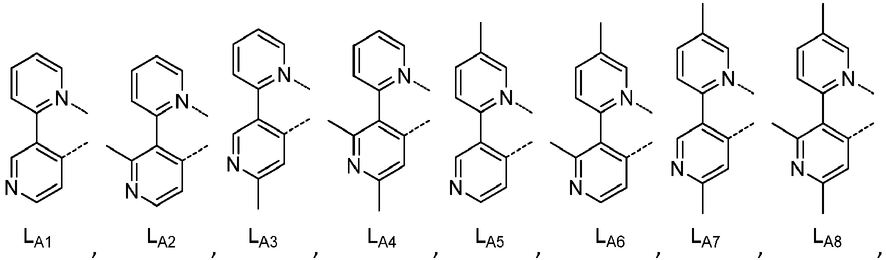 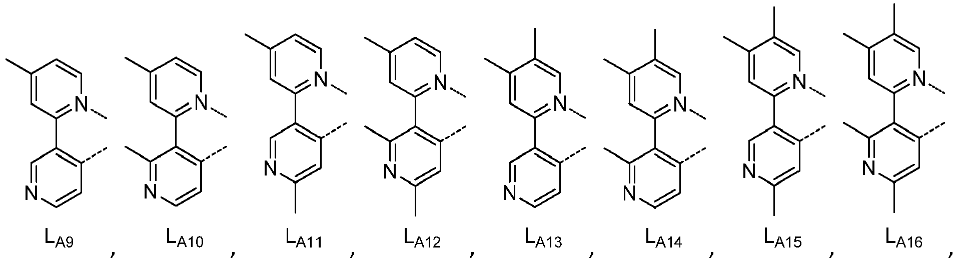 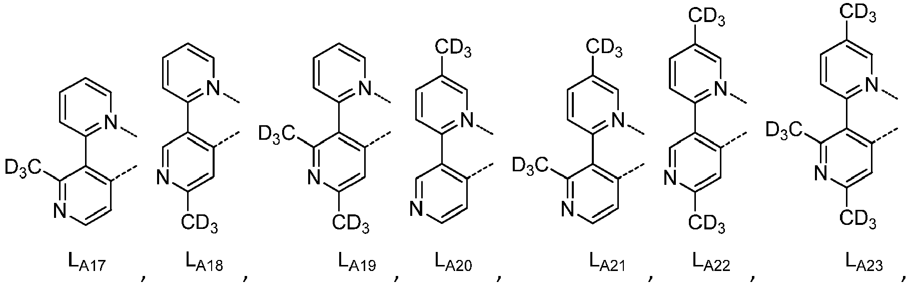 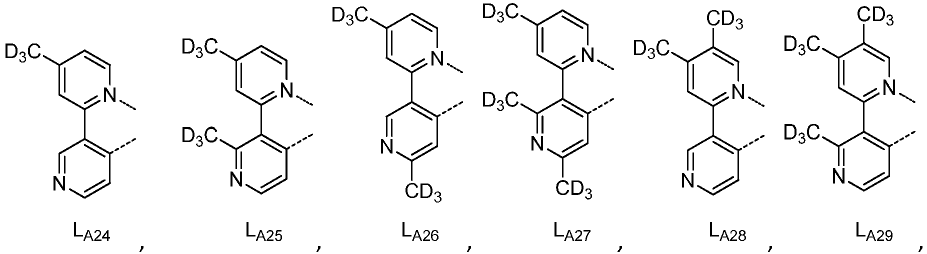 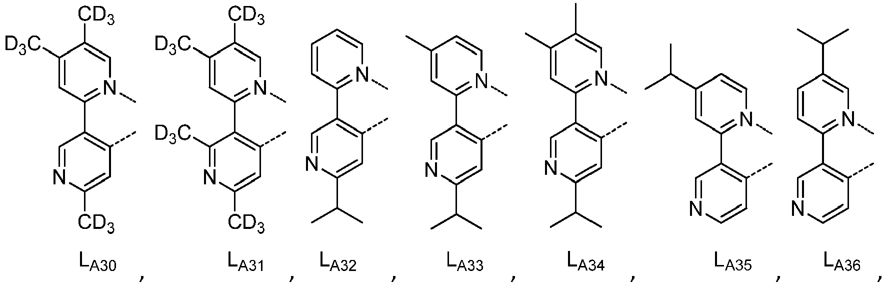 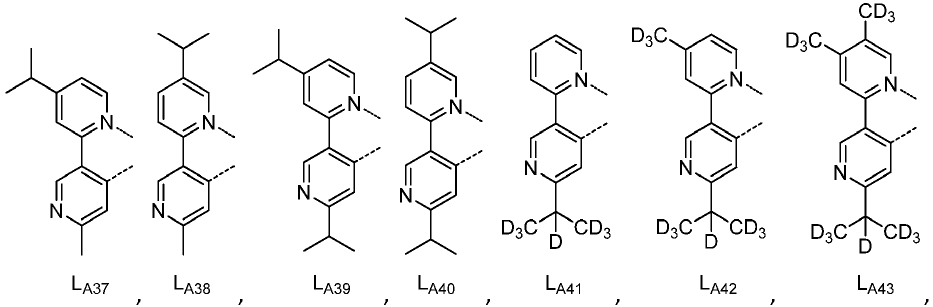 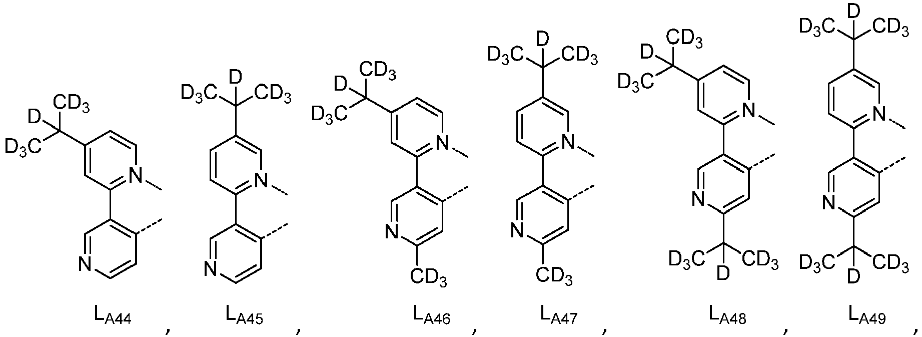 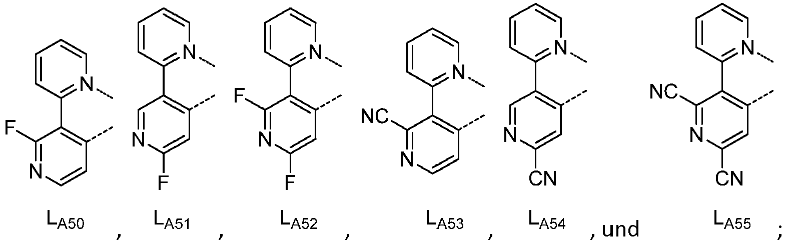
wobei n gleich 2 ist; und
wobei die Verbindung ausgewählt ist aus der Gruppe bestehend aus Verbindung 1 bis Verbindung 3300, wobei für jede Verbindung x die Formel Ir(L_{A*k*})₂(L_{B*j*}), *x* = 55*j* + *k -* 55 aufweist, wobei *k* eine ganze Zahl von 1 bis 55, und j eine ganze Zahl von 1 bis 60 ist.

14. Eine erste Vorrichtung umfassend eine erste, organische, lichtemittierende Vorrichtung, die erste, organische, lichtemittierende Vorrichtung umfassend:
eine Anode;
eine Kathode; und
eine organische Schicht, angeordnet zwischen der Anode und the Kathode, umfassend eine Verbindung gemäß der Formel Ir(L_{A})ₙ(L_{B})₃₋ₙ, mit der folgenden Struktur: 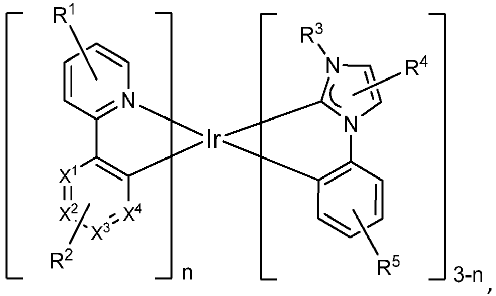 Formel I;
wobei R¹ und R⁵ jeweils unabhängig für mono-, di-, tri-, oder tetra-Substitution, oder keine Substitution stehen;
wobei R² für bis zu tri-Substitution, oder keine Substitution steht;
wobei R⁴ für mono-, oder di-Substitution, oder keine Substitution steht;
wobei X¹, X², X³, und X⁴ jeweils unabhängig C oder N sind;
wobei beliebige benachbarte Substituenten aus R¹, R², R³, R⁴, und R⁵ gegebenenfalls miteinander verbunden sind um einen Ring zu bilden;
wobei jeder von R¹, R², R³, R⁴, und R⁵ unabhängig ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkynyl, Aryl, Heteroaryl, Acyl, Carbonyl, Carbonsäuren, Ester, Nitril, Isonitril, Sulfanyl, Sulfinyl, Sulfonyl, Phosphino, und Kombinationen davon; und
wobei n entweder 1 oder 2 ist;
**dadurch gekennzeichnet, dass** mindestens einer von X¹, X², X³, und X⁴ N ist.

15. Eine Formulierung umfassend eine Verbindung gemäß der Formel Ir(L_{A})ₙ(L_{B})₃₋ₙ, mit der folgenden Struktur: 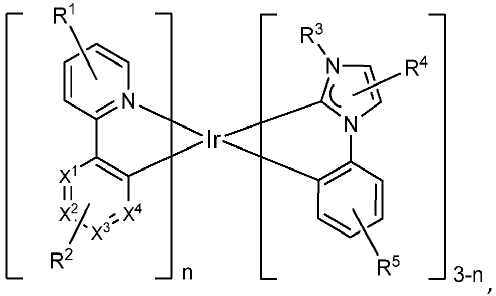 Formel I;
wobei R¹ und R⁵ jeweils unabhängig für mono-, di-, tri-, oder tetra-Substitution, oder keine Substitution stehen;
wobei R² für bis zu tri-Substitution, oder keine Substitution steht;
wobei R⁴ für mono-, oder di-Substitution, oder keine Substitution steht;
wobei X¹, X², X³, und X⁴ jeweils unabhängig C oder N sind;
wobei beliebige benachbarte Substituenten aus R¹, R², R³, R⁴, und R⁵ gegebenenfalls miteinander verbunden sind um einen Ring zu bilden;
wobei jeder von R¹, R², R³, R⁴, und R⁵ unabhängig ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkynyl, Aryl, Heteroaryl, Acyl, Carbonyl, Carbonsäuren, Ester, Nitril, Isonitril, Sulfanyl, Sulfinyl, Sulfonyl, Phosphino, und Kombinationen davon; und
wobei n entweder 1 oder 2 ist;
**dadurch gekennzeichnet, dass** mindestens einer von X¹, X², X³, und X⁴ N ist.

## Revendications

1. Un composé étant représenté par la formule Ir(L_{A})ₙ(L_{B})₃₋ₙ, ayant la structure : 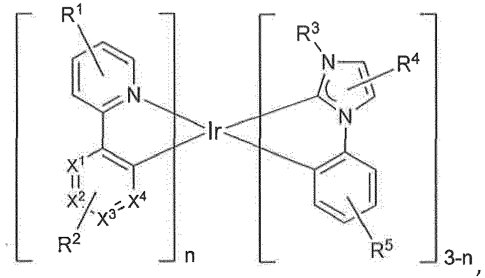 Formule I ;
où R¹ et R⁵ représentent chacun indépendamment une mono, di, tri ou tétra substitution, ou pas de substitution ;
où R² représente jusqu'à une tri substitution, ou pas de substitution ;
où R⁴ représente une mono ou di substitution, ou pas de substitution ;
où X¹, X², X³, et X⁴ sont chacun indépendamment C ou N ;
où tous substituants adjacents de R¹, R², R³, R⁴ et R⁵ sont éventuellement liés ensemble pour former un cycle ;
où chaque R¹, R², R³, R⁴, et R⁵ est indépendamment sélectionné parmi le groupe constitué d'hydrogène, deutérium, halogénure, alkyle, cycloalkyle, hétéroalkyle, arylalkyle, alkoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et de combinaisons de ceux-ci ; et
où n est 1 ou 2 ;
**caractérisé en ce qu'**au moins un de X¹, X², X³ et X⁴ est N.

2. Le composé selon la revendication 1, où n est 1.

3. Le composé selon la revendication 1, où n est 2.

4. Le composé selon l'une quelconque des revendications 1 à 3, où le composé est représenté par la formule : 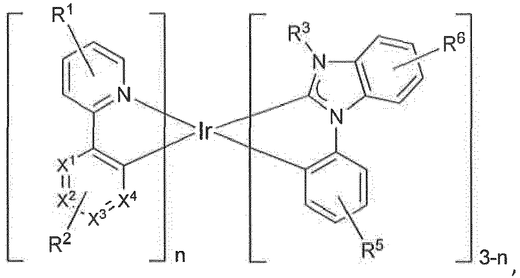 Formule II ;
où R⁶ représente une mono, di, tri ou tétra substitution, ou pas de substitution ;
où toutes substitutions adjacentes de R⁶ sont éventuellement liées ensemble pour former un cycle ; et
où chaque R⁶ est indépendamment sélectionné parmi le groupe constitué d'hydrogène, deutérium, halogénure, alkyle, cycloalkyle, hétéroalkyle, arylalkyle, alkoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et de combinaisons de ceux-ci.

5. Le composé selon la revendication 4, où un seul de X¹, X², X³ et X⁴ est N.

6. Le composé selon l'une quelconque des revendications 1 à 5, où R¹ est sélectionné parmi le groupe constitué d'hydrogène, deutérium, alkyle, cycloalkyle, et de combinaisons de ceux-ci.

7. Le composé selon l'une quelconque des revendications 1 à 6, où R² est sélectionné parmi le groupe constitué d'hydrogène, deutérium, halogénure, alkyle, cycloalkyle, nitrile, et de combinaisons de ceux-ci.

8. Le composé selon l'une quelconque des revendications 1 à 7, où R³ est alkyle ou cycloakyle.

9. Le composé selon l'une quelconque des revendications 1 à 7, où R³ est aryle ou aryle substitué.

10. Le composé selon la revendication 1, où le composé est sélectionné parmi le groupe constitué de : 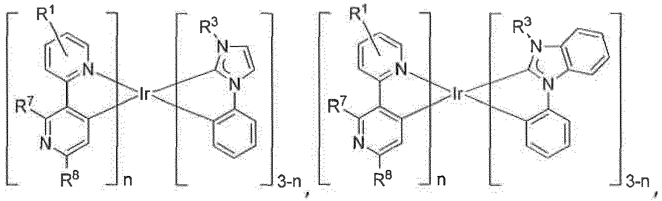 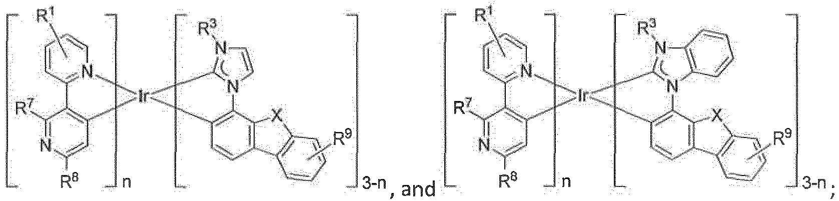
où R⁹ représente une mono, di, tri ou tétra substitution, ou pas de substitution ;
où chaque R⁷, R⁸, et R⁹ est indépendamment sélectionné parmi le groupe constitué d'hydrogène, deutérium, halogénure, alkyle, cycloalkyle, hétéroalkyle, arylalkyle, alkoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et de combinaisons de ceux-ci ; et
où X est O ou S.

11. Le composé selon l'une quelconque des revendications 1 à 3, et 8 ou 9, où LA est sélectionné parmi le groupe constitué de :

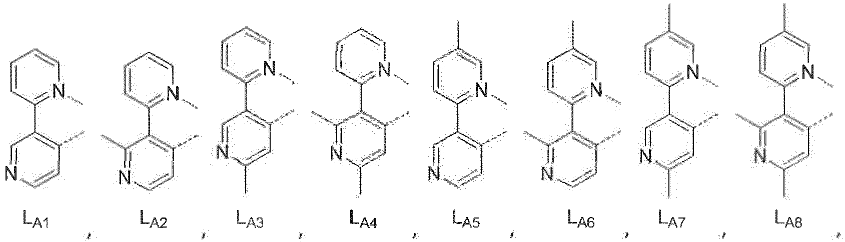

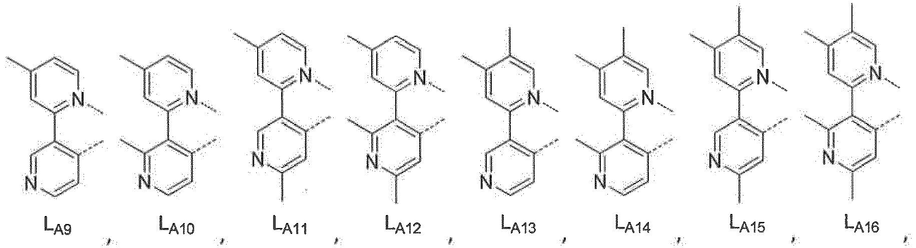

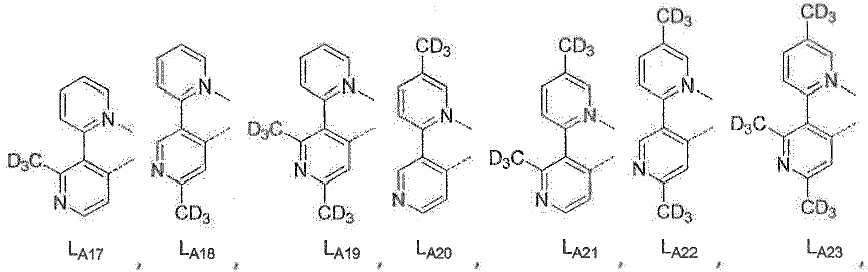

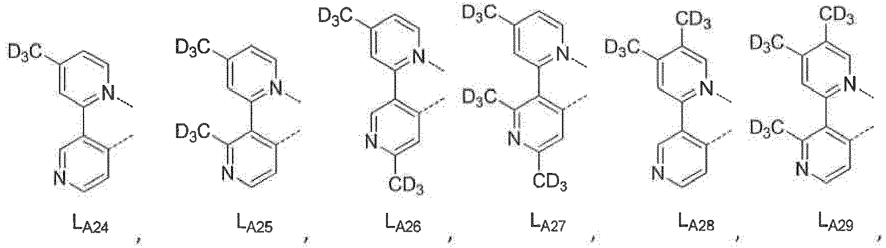

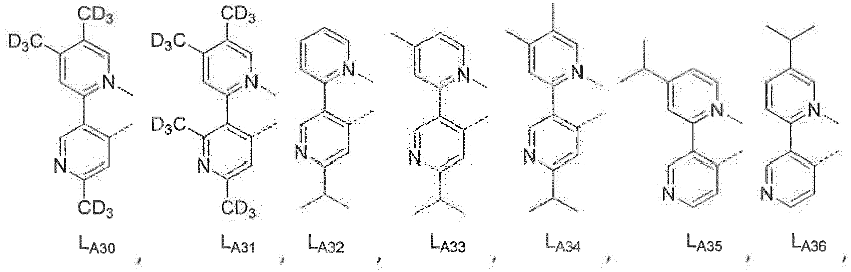

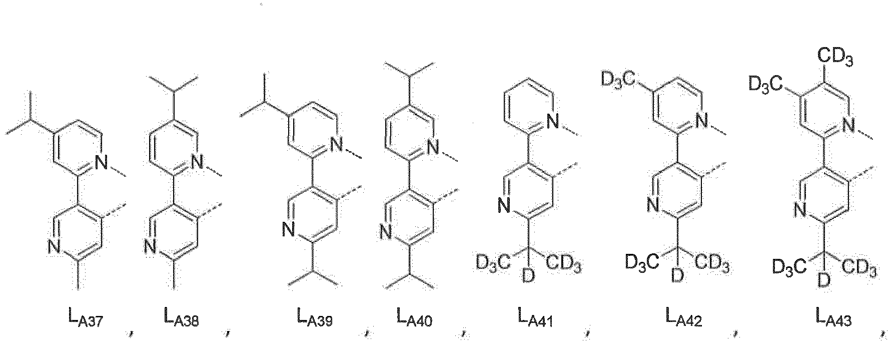

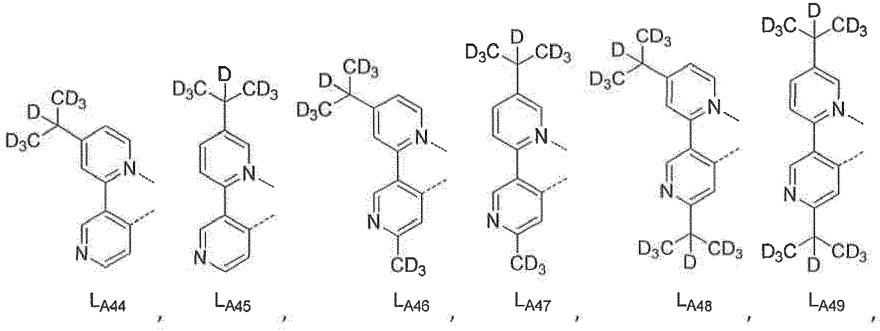

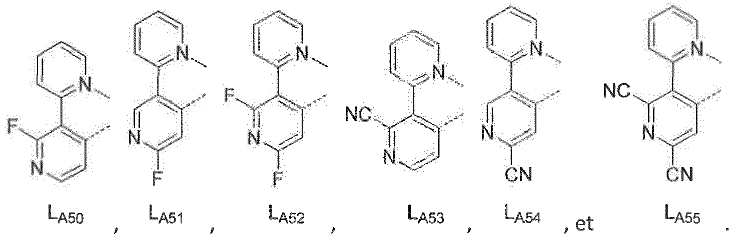

12. Le composé selon l'une quelconque des revendications 1 à 7, où L_{B} est sélectionné parmi le groupe constitué de : 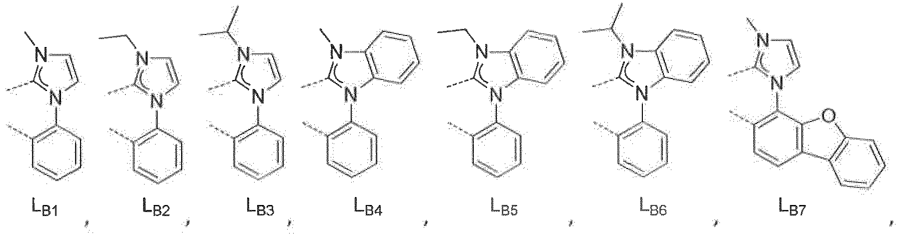 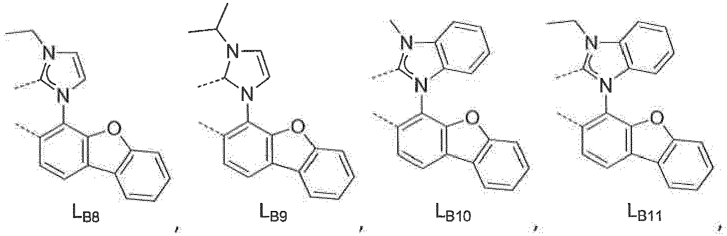 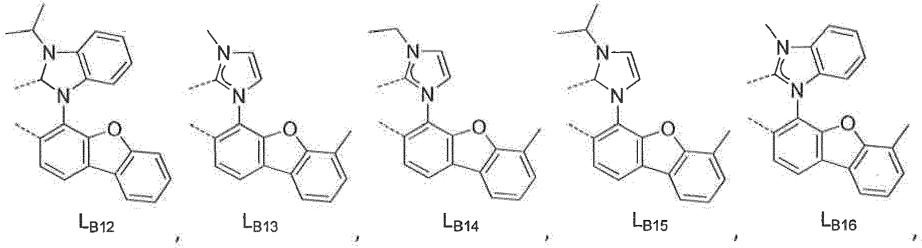 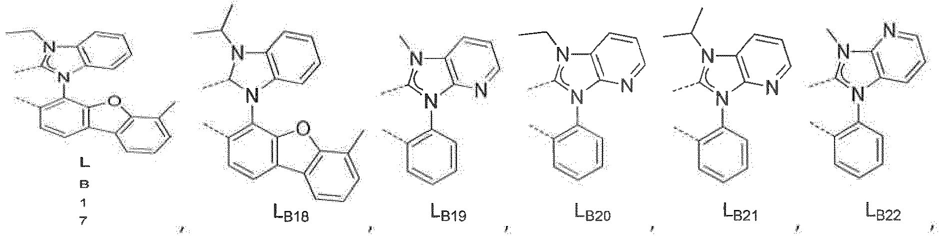 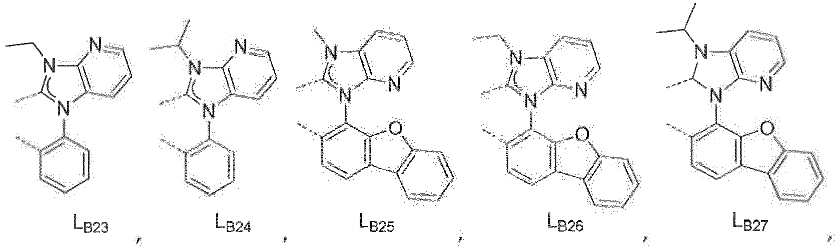 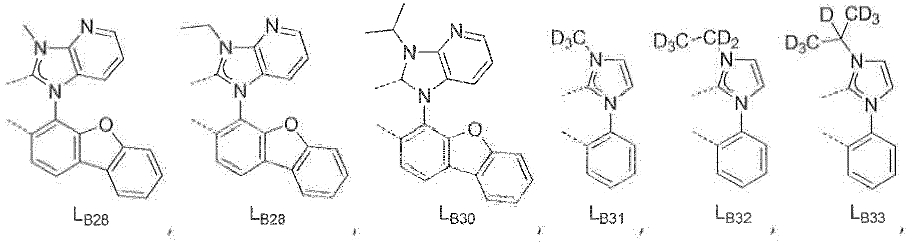 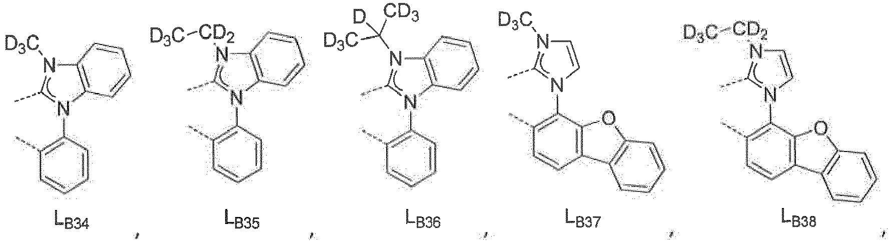 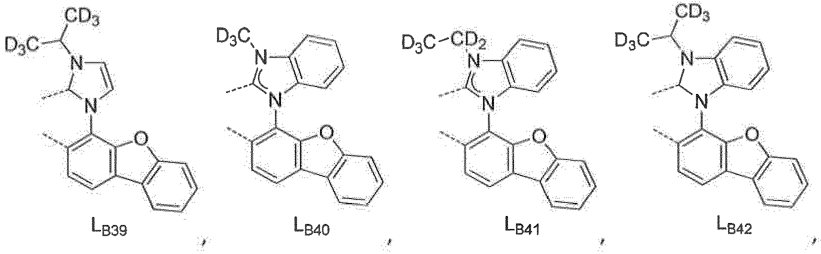 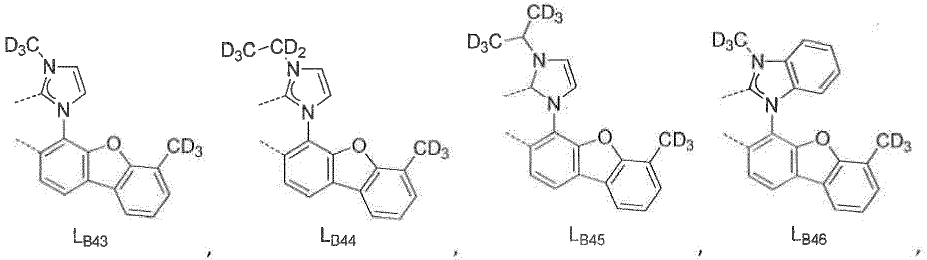 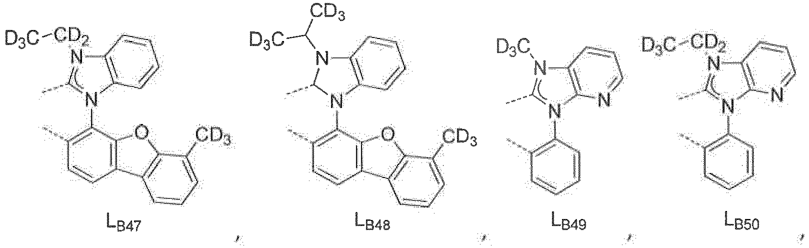 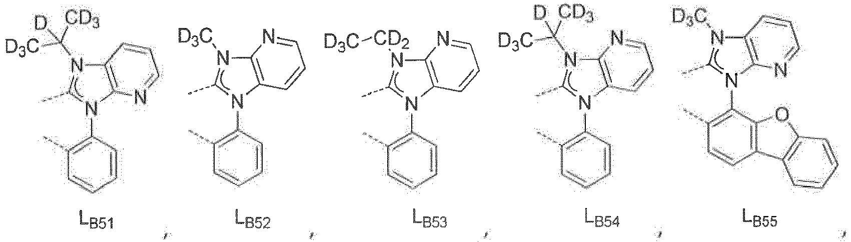 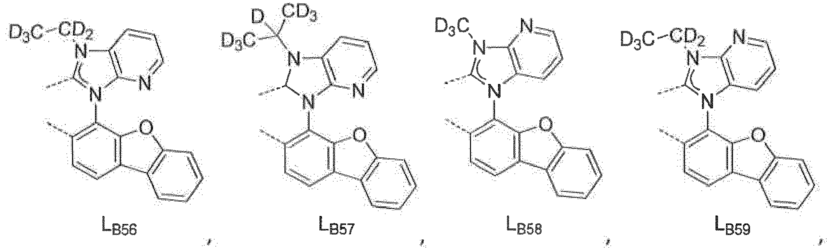 et

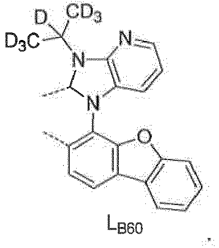

13. Composé selon la revendication 12, où L_{A} est sélectionné parmi le groupe constitué de : 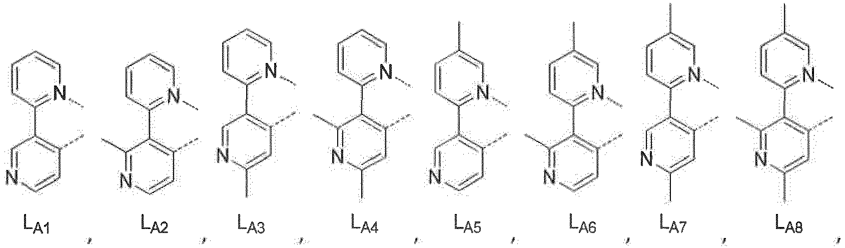 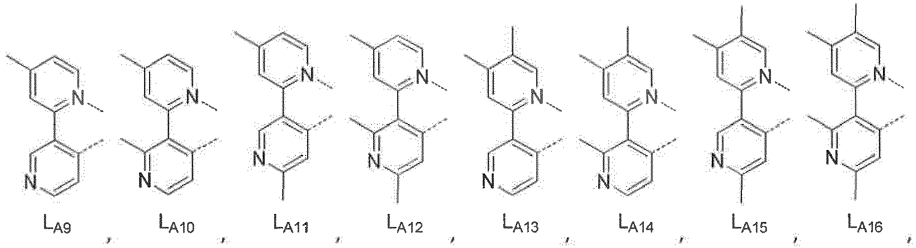 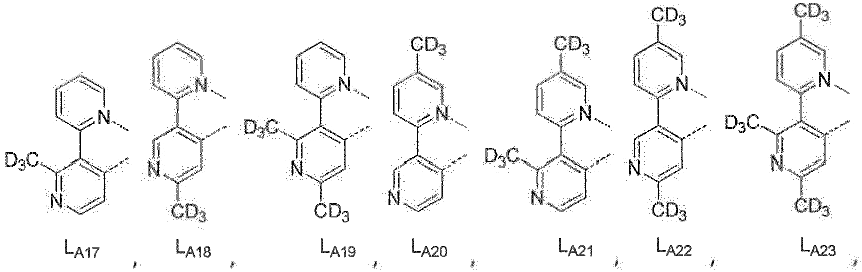 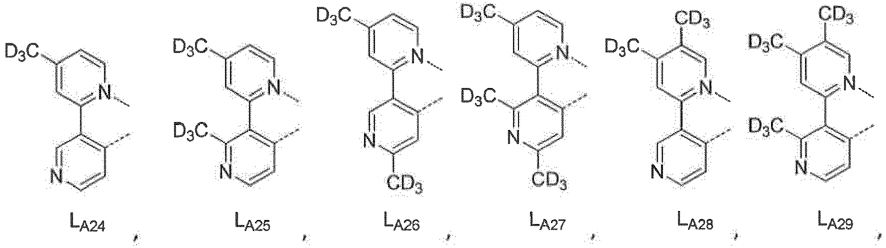 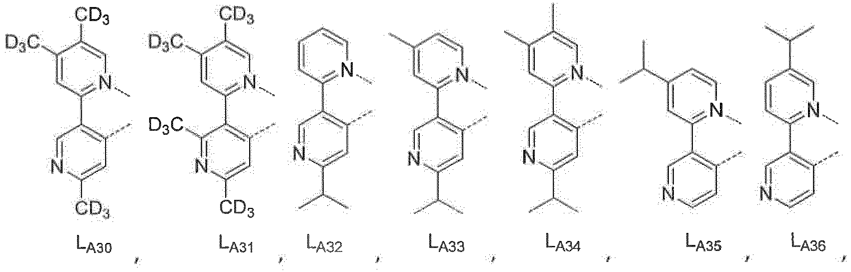 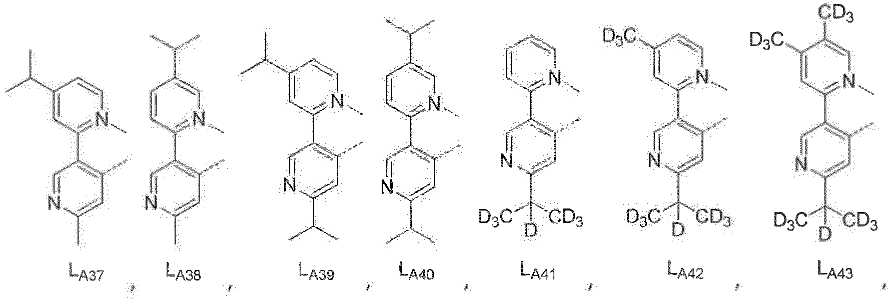 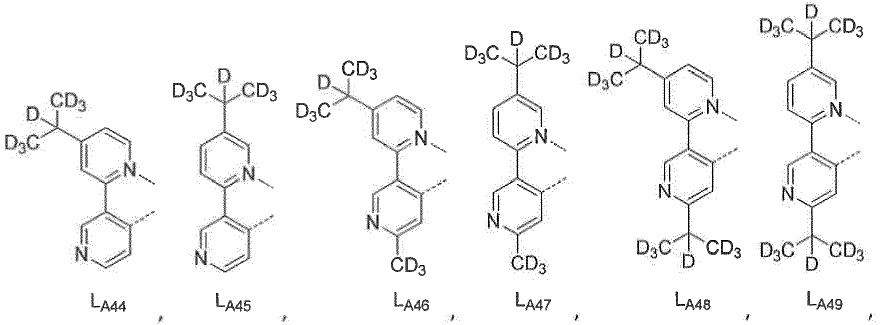 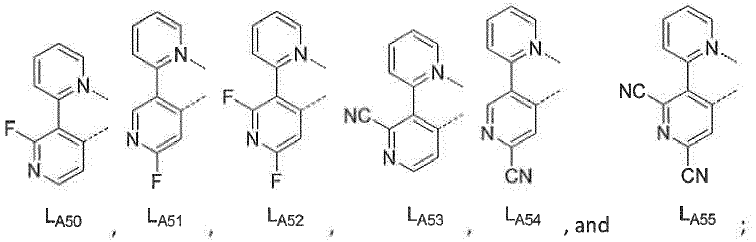
où n est 2 ; et
où le composé est sélectionné parmi le groupe constitué du composé 1 au composé 3300, où pour chaque composé x est représenté par la formule Ir(L_{Ak})₂(L_{B*j*}), *x* = 55*j* + *k -* 55, où *k* est un entier de 1 à 55, et j est un entier de 1 à 60.

14. Un premier dispositif comprenant un premier dispositif électroluminescent organique, le premier dispositif électroluminescent organique comprenant :
uneanode;
une cathode ; et
une couche organique, située entre l'anode et la cathode, comprenant un composé étant représenté par la formule Ir(L_{A})ₙ(L_{B})₃₋ₙ, ayant la structure : 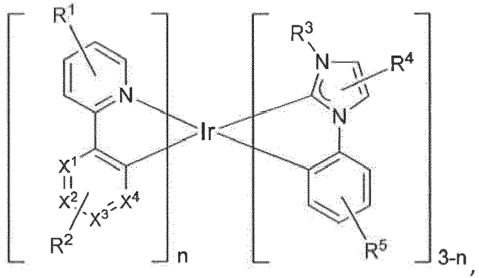 Formule I ;
où R¹ et R⁵ représentent chacun indépendamment une mono, di, tri ou tétra substitution, ou pas de substitution ;
où R² représente jusqu'à une tri substitution, ou pas de substitution ;
où R⁴ représente une mono ou di substitution, ou pas de substitution ;
où X¹, X², X³, et X⁴ sont chacun indépendamment C ou N ;
où au moins un de X¹, X², X³ et X⁴ est N ;
où tous substituants adjacents de R¹, R², R³, R⁴ et R⁵ sont éventuellement liés ensemble pour former un cycle ;
où chaque R¹, R², R³, R⁴, et R⁵ est indépendamment sélectionné parmi le groupe constitué d'hydrogène, deutérium, halogénure, alkyle, cycloalkyle, hétéroalkyle, arylalkyle, alkoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, cyano, et de combinaisons de ceux-ci ; et
où n est 1 ou 2.

15. Une formulation comprenant un composé étant représenté par la formule Ir(L_{A})ₙ(L_{B})₃₋ₙ, ayant la structure : 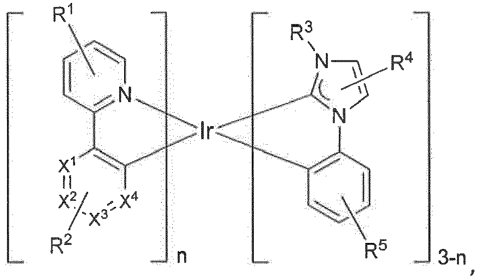 Formule I ;
où R¹ et R⁵ représentent chacun indépendamment une mono, di, tri ou tétra substitution, ou pas de substitution ;
où R² représente jusqu'à une tri substitution, ou pas de substitution ;
où R⁴ représente une mono ou di substitution, ou pas de substitution ;
où X¹, X², X³, et X⁴ sont chacun indépendamment C ou N ;
où au moins un de X¹, X², X³ et X⁴ est N ;
où tous substituants adjacents de R¹, R², R³, R⁴ et R⁵ sont éventuellement liés ensemble pour former un cycle ;
où chaque R¹, R², R³, R⁴, et R⁵ est indépendamment sélectionné parmi le groupe constitué d'hydrogène, deutérium, halogénure, alkyle, cycloalkyle, hétéroalkyle, arylalkyle, alkoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, cyano, et de combinaisons de ceux-ci ; et
où n est 1 ou 2.
